# EUROPEAN PATENT APPLICATION

(11) **EP 4 418 483 A1**
(43) Date of publication of application: **21.08.2024**
(21) Application number: 21966625.2
(22) Date of filing: 06.12.2021
(51) Int. Cl.: H02H 9/04

(54) **ELECTROSTATIC PROTECTION CIRCUIT, CHIP, AND TERMINAL**

(71) Applicant: Huawei Technologies Co., Ltd., Shenzhen, Guangdong 518129 (CN)
(72) Inventor: GAO, Xin, Shenzhen, Guangdong 518129 (CN); WANG, Lihui, Shenzhen, Guangdong 518129 (CN)
(74) Representative: Pfenning, Meinig & Partner mbB
(86) International application number: PCT/CN2021/135828
(87) International publication number: WO 2023/102697

(57) **Abstract**

Embodiments of this application provide an electrostatic discharge protection circuit, a chip, and a terminal, and relate to the field of chip technologies. A first switch is coupled between a first voltage end and a ground end. This can implement electrostatic discharge, and can further avoid a case in which a protected component is damaged because a total voltage on a path from the first voltage end to the ground end is greater than a breakdown voltage threshold. The electrostatic discharge protection circuit includes a control circuit, the first switch, the first voltage end, a second voltage end, and the ground end. The second voltage end is configured to supply a working voltage to the first voltage end. The first switch and the protected component are coupled in parallel between the first voltage end and the ground end. The control circuit is configured to: when detecting that the first voltage end sends an electrostatic signal to the second voltage end, send a control signal to the first switch. The first switch is configured to be turned on under control of the control signal.

## Description

### TECHNICAL FIELD

This application relates to the field of chip technologies, and in particular, to an electrostatic discharge protection circuit, a chip, and a terminal.

### BACKGROUND

After a chip generates an electric charge due to reasons such as manufacturing, transportation, packaging, or testing, if a pin of the chip is connected to a ground end, electrostatic discharge (electrostatic discharge, ESD) occurs. During the electrostatic discharge process, a component in the chip is easily damaged, further affecting a function of the chip.

Therefore, how to prevent the component from being damaged due to the electrostatic discharge is an urgent problem to be resolved currently.

### SUMMARY

To resolve the foregoing technical problem, this application provides an electrostatic discharge protection circuit, a chip, and a terminal. A first switch is coupled between a first voltage end and a ground end. This can implement electrostatic discharge, and can further avoid a case in which a protected component is damaged because a total voltage on a path from the first voltage end to the ground end is greater than a breakdown voltage threshold.

According to a first aspect, this application provides an electrostatic discharge protection circuit. The electrostatic discharge protection circuit includes a control circuit, a first switch, a first voltage end, a second voltage end, and a ground end. The second voltage end is configured to supply a working voltage to the first voltage end. The first switch and a protected component are coupled in parallel between the first voltage end and the ground end. The control circuit is configured to: when detecting that the first voltage end sends an electrostatic signal to the second voltage end, send a control signal to the first switch. The first switch is configured to be turned on under control of the control signal.

In this application, the first switch is coupled between the first voltage end and the ground end, so that the first switch is turned on under the control of the control signal, and the first voltage end, the first switch, and the ground end form a conducting path. In this way, an electrostatic voltage on the first voltage end may be discharged through the first switch, to avoid an extremely high electrostatic voltage on the first voltage end, and further avoid a case in which the protected component is damaged because of impact on the protected component that is caused by a high peak current formed when a high electrostatic voltage is discharged transiently.

In addition, in this application, the first switch and the protected component are coupled in parallel between the first voltage end and the ground end. During electrostatic discharge, static electricity on the first voltage end may be discharged through the conducting path formed by the first voltage end, the first switch, and the ground end. In comparison with a conventional technology, in this application, during the electrostatic discharge, the second voltage end does not need to be passed through, so that an electrostatic discharge path can be shortened, and a parasitic resistance on the electrostatic discharge path can be reduced. In addition, in this application, it may be further controlled that a component other than the first switch is no longer integrated on the conducting path formed by the first voltage end, the first switch, and the ground end. In this way, in comparison with the conventional technology, in this application, a total voltage on a path from the first voltage end to the ground end is no longer affected by impedance of the another component. The total voltage on the path from the first voltage end to the ground end can be greatly reduced by reducing the parasitic resistance on the electrostatic discharge path and eliminating impedance impact of the another component, to avoid a case in which the protected component is damaged because the total voltage on the path from the first voltage end to the ground end is greater than a breakdown voltage threshold.

In some possible implementations, the electrostatic discharge protection circuit further includes a second switch, and the second switch is coupled between the second voltage end and the ground end. The control circuit is further configured to: when detecting that the first voltage end sends the electrostatic signal to the second voltage end, send the control signal to the second switch. The second switch is configured to be turned on under the control of the control signal. After the second switch is turned on, the first voltage end, the second voltage end, the second switch, and the ground end may form a conducting path. In addition to being discharged through the first switch, the electrostatic voltage on the first voltage end may be further discharged through the second switch. The first voltage end discharges at least a part of the electrostatic voltage through the second switch, to reduce a voltage value of the first voltage end, and avoid leakage of the working voltage through the first switch that is caused because the first switch is turned on by mistake when the voltage of the first voltage end is extremely high, a power supply supplies the working voltage to the first voltage end through the second voltage end, and the first voltage end is powered on extremely quickly.

In some possible implementations, the control circuit includes a detection circuit. The detection circuit is connected in series between the second voltage end and the ground end, and is configured to: when detecting that the first voltage end sends the electrostatic signal to the second voltage end, output a detection signal. The detection signal may be used as the control signal. The detection circuit is further configured to send the detection signal to the first switch and the second switch. When detecting that the first voltage end TVDD sends the electrostatic signal to the second voltage end VDD, the detection circuit may determine that flowing of an electric charge on the first voltage end TVDD to the second voltage end VDD is an electrostatic discharge event, and directly input the detection signal to the second switch to control the first switch and the second switch to be turned on. This implements the electrostatic discharge through the first switch and the second switch.

In some possible implementations, the control circuit further includes a first inverter. The detection circuit is configured to: when detecting that the first voltage end sends the electrostatic signal to the second voltage end, send the detection signal to the first inverter. The first inverter is configured to: invert the detection signal to obtain the control signal, and output the control signal, where the detection signal and the control signal are high and low electrical levels of each other. When detecting that the first voltage end TVDD sends the electrostatic signal to the second voltage end VDD, the detection circuit may determine that flowing of the electric charge on the first voltage end TVDD to the second voltage end VDD is the electrostatic discharge event, and output the detection signal. Then, the detection circuit sends the detection signal to the first inverter, and outputs, after the first inverter inverts the detection signal, the control signal obtained through inversion.

The first inverter may send the control signal to the second switch, to control the second switch to be turned on. This implements the electrostatic discharge through the second switch. The first inverter may further send the control signal to the first switch, to control the first switch to be turned on. This implements the electrostatic discharge through the first switch. In comparison with the following solution in which the control circuit includes a second inverter, in this solution, because the control circuit does not include the second inverter, a layout area of the electrostatic discharge protection circuit can be reduced.

In comparison with the foregoing solution in which the control circuit does not include the first inverter, the solution in which the control circuit includes the first inverter may be applied to a scenario in which paths from the detection circuit to the first switch and the second switch are extremely long. This avoids a case in which the first switch and the second switch cannot be fully turned on because a signal output from the detection circuit is consumed on the path due to the extremely long paths from the detection circuit to the first switch and the second switch.

Alternatively, the control circuit further includes a second inverter. The detection circuit is further configured to: when detecting that the first voltage end sends the electrostatic signal to the second voltage end, send the detection signal to the second inverter. The second inverter is configured to: invert the detection signal to obtain a control signal, and send the control signal to the first switch, where the detection signal and the control signal are high and low electrical levels of each other, to control the first switch to be turned on. This implements the electrostatic discharge through the first switch. However, the first inverter still sends the control signal to the second switch, to control the second switch to be turned on. This implements the electrostatic discharge through the second switch.

The detection circuit in this solution may directly send the detection signal to the second inverter. Although the second inverter also has channel impedance, a path on which the second inverter is coupled to the first switch is short. After the second inverter transmits the voltage of the first voltage end to the first switch, the first switch may be fully turned on, in other words, the first switch is strongly turned on. In this way, efficiency of the electrostatic discharge from the first voltage end through the first switch is not affected. Therefore, in comparison with the foregoing solution in which the control circuit includes the first inverter but does not include the second inverter, this solution can improve the efficiency of the electrostatic discharge from the first voltage end through the first switch.

The following describes the first switch, the second switch, the first inverter, and the second inverter. For example, the first switch may include a first transistor, the second switch may include a second transistor, and the first inverter includes a first P-type transistor and a first N-type transistor. A gate of the second transistor is coupled to the first inverter, a first electrode is coupled to the second voltage end, and a second electrode is coupled to the ground end. A gate of the first P-type transistor is coupled to an output end of the detection circuit, a first electrode is coupled to the second voltage end, and a second electrode is coupled to a gate of the first transistor and the gate of the second transistor. A gate of the first N-type transistor is coupled to the output end of the detection circuit, a first electrode is coupled to the ground end, and a second electrode is coupled to the gate of the first transistor and the gate of the second transistor.

For another example, the first switch may include a first transistor, the second switch may include a second transistor, the first inverter includes a first P-type transistor and a first N-type transistor, and the second inverter includes a second P-type transistor and a second N-type transistor. A first electrode of the second transistor is coupled to the second voltage end, and a second electrode is coupled to the ground end. A gate of the first P-type transistor is coupled to an output end of the detection circuit, a first electrode is coupled to the second voltage end, and a second electrode is coupled to a gate of the second transistor. A gate of the first N-type transistor is coupled to the output end of the detection circuit, a first electrode is coupled to the ground end, and a second electrode is coupled to the gate of the second transistor. A gate of the second P-type transistor is coupled to the output end of the detection circuit, a first electrode is coupled to the first voltage end, and a second electrode is coupled to a gate of the first transistor. A gate of the second N-type transistor is coupled to the output end of the detection circuit, a first electrode is coupled to the ground end, and a second electrode is coupled to the gate of the first transistor.

For another example, the first switch may include a first transistor, and the second switch may include a second transistor. When the control circuit does not include the first inverter and the second inverter, a gate of the first transistor and a gate of the second transistor may be coupled to an output end of the detection circuit.

In some possible implementations, the first transistor and the second transistor may be N-type transistors, or may be P-type transistors. The detection circuit is a resistor-capacitor circuit, and the resistor-capacitor circuit includes a resistor, a capacitor, and an output end coupled between the resistor and the capacitor.

For example, the resistor is coupled between the second voltage end and the output end of the capacitor-resistor circuit, and the capacitor is coupled between the output end of the capacitor-resistor circuit and the ground end. When the first switch and the second switch receive the control signal sent by the first inverter, or when the first switch receives the control signal sent by the second inverter and the second switch receives the control signal sent by the first inverter, the resistor R has a delay effect on a high electrical level of the second voltage end VDD. Therefore, a detection signal output from the RC circuit is a low electrical level. The control signal obtained through inversion is a high electrical level opposite to the low electrical level. Under control of the high electrical level, the N-type first transistor and the N-type second transistor are turned on. Alternatively, when the first switch and the second switch receive the control signal sent by the detection circuit, the resistor R has a delay effect on a high electrical level of the second voltage end VDD. Therefore, a detection signal output from the RC circuit is a low electrical level, and the P-type first transistor and the P-type second transistor are turned on at the low electrical level.

For example, the capacitor is coupled between the second voltage end and the output end of the capacitor-resistor circuit, and the resistor is coupled between the output end of the capacitor-resistor circuit and the ground end. When the first switch and the second switch receive the control signal sent by the first inverter, or when the first switch receives the control signal sent by the second inverter and the second switch receives the control signal sent by the first inverter, because the capacitor C is coupled between the second voltage end VDD and the output end of the RC circuit, the capacitor C has no delay effect on a high electrical level of the second voltage end VDD, and the high electrical level of the second voltage end VDD may pull up the output end of the RC circuit through the capacitor C. Therefore, a detection signal output from the RC circuit is also a high electrical level. The control signal obtained through inversion is a low electrical level opposite to the high electrical level. Under control of the low electrical level, the P-type first transistor and the P-type second transistor are turned on. Alternatively, when the first switch and the second switch receive the control signal sent by the detection circuit, because the capacitor C is coupled between the second voltage end VDD and the output end of the RC circuit, the capacitor C has no delay effect on a high electrical level of the second voltage end VDD, and the high electrical level of the second voltage end VDD may pull up the output end of the RC circuit through the capacitor C. Therefore, a detection signal output from the RC circuit is also a high electrical level. Under control of the high electrical level, the N-type first transistor and the N-type second transistor are turned on.

In some possible implementations, the electrostatic discharge protection circuit further includes a third transistor, and the third transistor is coupled between the first voltage end and the second voltage end. When the second voltage end supplies the working voltage to the first voltage end, the third transistor is used as a triode. When the first voltage end sends the electrostatic signal to the second voltage end, a gate of the third transistor may be floated, and the third transistor is reused as a diode.

According to a second aspect, a chip is provided. The chip includes the electrostatic discharge protection circuit according to the first aspect.

An implementation of the second aspect corresponds to any one of the first aspect and the implementations of the first aspect. For technical effects corresponding to the implementation of the second aspect, refer to technical effects corresponding to any one of the first aspect and the implementations of the first aspect. Details are not described herein again.

According to a third aspect, a terminal is provided. The terminal includes the chip according to the second aspect.

An implementation of the third aspect corresponds to any one of the first aspect and the implementations of the first aspect. For technical effects corresponding to the implementation of the third aspect, refer to technical effects corresponding to any one of the first aspect and the implementations of the first aspect. Details are not described herein again.

### BRIEF DESCRIPTION OF DRAWINGS

FIG. 1 is a circuit diagram of a protected circuit integrated in a chip according to an embodiment of this application;
FIG. 2 is a diagram of a connection relationship between an electrostatic discharge clamping circuit and a protected circuit in a conventional technology;
FIG. 3 is a diagram of a connection relationship between an electrostatic discharge clamping circuit and a protected circuit in a conventional technology;
FIG. 4a is a circuit diagram of an electrostatic discharge protection circuit according to an embodiment of this application;
FIG. 4b is a circuit diagram of an electrostatic discharge protection circuit according to an embodiment of this application;
FIG. 5a is a circuit diagram of an electrostatic discharge protection circuit according to an embodiment of this application;
FIG. 5b is a circuit diagram of an electrostatic discharge protection circuit according to an embodiment of this application;
FIG. 6a is a circuit diagram of an electrostatic discharge protection circuit according to an embodiment of this application;
FIG. 6b is a circuit diagram of an electrostatic discharge protection circuit according to an embodiment of this application;
FIG. 7a is a circuit diagram of an electrostatic discharge protection circuit according to an embodiment of this application;
FIG. 7b is a circuit diagram of an electrostatic discharge protection circuit according to an embodiment of this application;
FIG. 8a is a circuit diagram of an electrostatic discharge protection circuit according to an embodiment of this application;
FIG. 8b is a circuit diagram of an electrostatic discharge protection circuit according to an embodiment of this application;
FIG. 9a is a circuit diagram of an electrostatic discharge protection circuit according to an embodiment of this application;
FIG. 9b is a circuit diagram of an electrostatic discharge protection circuit according to an embodiment of this application;
FIG. 10a is a circuit diagram of an electrostatic discharge protection circuit according to an embodiment of this application;
FIG. 10b is a circuit diagram of an electrostatic discharge protection circuit according to an embodiment of this application;
FIG. 11a is a circuit diagram of an electrostatic discharge protection circuit according to an embodiment of this application; and
FIG. 11b is a circuit diagram of an electrostatic discharge protection circuit according to an embodiment of this application.

### Reference numerals:

10-Control circuit; 11-Detection circuit; 12-First inverter; 13-Second inverter; 20-First switch; 30-Second switch; 50-Protected component; 60-Drive circuit; 100-Electrostatic discharge clamping circuit; and 200-Protected circuit.

### DESCRIPTION OF EMBODIMENTS

The following clearly and completely describes technical solutions in embodiments of this application with reference to the accompanying drawings in embodiments of this application. It is clear that the described embodiments are some but not all of embodiments of this application. All other embodiments obtained by a person of ordinary skill in the art based on embodiments of this application without creative efforts shall fall within the protection scope of this application.

The term "and/or" in this specification describes only an association relationship for describing associated objects and represents that three relationships may exist. For example, A and/or B may represent the following three cases: Only A exists, both A and B exist, and only B exists.

In the specification and claims in embodiments of this application, the terms "first", "second", and the like are used to distinguish between different objects, but are not used to describe a specific order of the objects. For example, a first target object, a second target object, and the like are used to distinguish between different target objects, but are not used to describe a specific order of the target objects.

In embodiments of this application, the term "example", "for example", or the like is used to represent giving an example, an illustration, or a description. Any embodiment or design scheme described as an "example" or "for example" in embodiments of this application should not be explained as being more preferred or having more advantages than another embodiment or design scheme. Exactly, use of the term "example", "for example", or the like is intended to present a related concept in a specific manner.

In descriptions of embodiments of this application, unless otherwise stated, "a plurality of" means two or more. For example, a plurality of processing units mean two or more processing units, and a plurality of systems mean two or more systems.

Embodiments of this application provide a terminal. The terminal may be a device including a chip, such as a mobile phone, a computer, a tablet computer, a television, an in-vehicle display, a smartwatch, a server, a memory, radar, a base station, or a car. Certainly, the terminal may alternatively be another device. A specific form of the terminal is not limited in embodiments of this application. For ease of description, the following uses an example in which the terminal is the mobile phone for description.

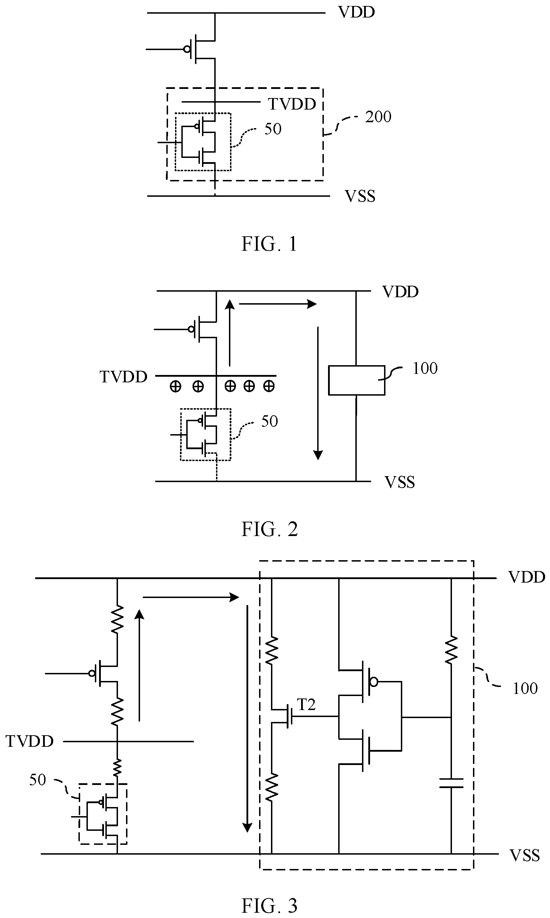

The mobile phone may include a plurality of chips, the chip includes one or more protected circuits, and each protected circuit includes one or more protected components. As shown in FIG. 1, a chip generates an electric charge in scenarios such as manufacturing, transportation, packaging, or testing. If the chip is in contact with the ground, electrostatic discharge occurs, and a protected component in a protected circuit 200 is damaged.

For example, as shown in FIG. 1, the protected circuit 200 may be registered in any circuit in the scenarios such as manufacturing, transportation, packaging, or testing, and the any circuit includes a second voltage end VDD and a ground end VSS. The protected circuit 200 includes a first voltage end TVDD and a protected component 50 coupled between the first voltage end TVDD and the ground end VSS. In FIG. 1, an example in which the protected component is an inverter including a P-type transistor and an N-type transistor is used. When the protected component 50 is in a working state, a power supply may supply a working voltage to the first voltage end TVDD through the second voltage end VDD. Further, the first voltage end TVDD may supply the working voltage to the protected component 50.

Static electricity in the chip may cause an electrostatic voltage on the protected circuit 200 to become higher. When the static electricity cannot be effectively discharged, the static electricity cannot be discharged from the protected circuit 200, but is stored in the P-type transistor and the N-type transistor that are of the protected component 50. In this case, a voltage of the first voltage end TVDD further becomes higher. If a transistor is a P-type transistor, the electrostatic voltage is stored in an N-well of the P-type transistor. Alternatively, if a transistor is an N-type transistor, a 2 kV electrostatic voltage is stored in a P-type substrate of the N-type transistor. Both the N-well of the P-type transistor and the P-type substrate of the N-type transistor occupy a large area in the transistor. The larger the areas of the N-well and P-type substrates are, the more electrostatic charges can be stored. A high peak current (peak current) is formed when a high electrostatic voltage is discharged transiently. This causes impact on the N-type transistor and the P-type transistor. In an extreme case, the N-type transistor and the P-type transistor are damaged.

It should be noted herein that the protected circuit 200 in this application may be any circuit integrated in the chip. In the foregoing example, the protected component 50 is the P-type transistor and the N-type transistor, which is merely an example. Optionally, the protected circuit 200 may be, for example, a low power consumption circuit. In this case, the protected component 50 in the protected circuit 200 may be a multi-threshold component (multi-threshold complementary metal-oxide-semiconductor, MTCMOS), a low dropout voltage regulator (low dropout regulator, LDO), a power gating (power gating) control component, or the like.

To prevent the protected component in the chip from being damaged by the electrostatic discharge, as shown in FIG. 2, a conventional technology proposes that an electrostatic discharge clamping circuit 100 is integrated in the chip, and the electrostatic voltage may be discharged through the electrostatic discharge clamping circuit 100, so that the protected circuit 200 is always in a safe state.

However, as shown in FIG. 3, if the electrostatic discharge clamping circuit 100 is coupled between the second voltage end VDD and the ground end VSS, the electrostatic discharge clamping circuit 100 can be turned on under control of a high electrical level, provided that the second voltage end VDD is at a high electrical level. The first voltage end TVDD is coupled to the second voltage end TVDD. Therefore, when the first voltage end TVDD is at a high electrical level, the first voltage end VDD may indirectly control the electrostatic discharge clamping circuit 100 to be turned on. Therefore, when the protected component 50 works normally, and the power supply supplies the working voltage to the first voltage end TVDD through the second voltage end VDD, if the first voltage end TVDD is powered on extremely quickly (for example, at an ns level to a µs level), the electrostatic discharge clamping circuit 100 may be turned on by mistake under indirect control of the first voltage end TVDD, the first voltage end TVDD, the electrostatic discharge clamping circuit 100, and the ground end VSS further form a conducting path, and the working voltage of the first voltage end TVDD directly flows to the ground end VSS through a branch at which the electrostatic discharge clamping circuit 100 is located, in other words, the working voltage of the first voltage end TVDD leaks through the branch at which the electrostatic discharge clamping circuit 100 is located. Consequently, the voltage of the first voltage end TVDD is always low, and cannot reach an ideal voltage value. This affects normal working of the transistor.

In addition, as shown in FIG. 3, the electrostatic discharge clamping circuit 100 is integrated between the second voltage end VDD and the ground end VSS. When a current on a conducting path from the second voltage end VDD to the ground end VSS is basically unchanged, it needs to be further ensured that a resistance between the first voltage end TVDD and the second voltage end VDD is extremely low, so that a total voltage on a path from the first voltage end TVDD to the ground end VSS through the second voltage end VDD is less than a breakdown voltage threshold. It should be noted herein that the breakdown voltage threshold means that the protected component 50 is at an allowable maximum withstand voltage. If a clamping voltage on the electrostatic discharge clamping circuit 100 exceeds the breakdown voltage threshold, the protected component 50 is permanently damaged due to breakdown.

However, in the conventional technology, during the electrostatic discharge through the conducting path formed by the first voltage end TVDD, the electrostatic discharge clamping circuit 100, and the ground end VSS, because a plurality of components may be integrated between the first voltage end TVDD and the second voltage end VDD, and impedance of the plurality of components cannot be controlled, when the impedance of the plurality of components is high, under action of the impedance of the plurality of components between the first voltage end TVDD and the second voltage end VDD, the clamping voltage on the electrostatic discharge clamping circuit 100, and a parasitic resistance on the path from the first voltage end TVDD to the second voltage end VDD, the total voltage on the path from the first voltage end TVDD to the ground end VSS may be greater than the breakdown voltage threshold, and the protected component 50 is still damaged. The component between the first voltage end TVDD and the second voltage end VDD may include a diode. During the electrostatic discharge, the electric charge on the first voltage end TVDD may flow to the second voltage end VDD through the diode. However, the diode has a small size, and has large impedance when being turned on. This greatly increases the total voltage on the path from the first voltage end TVDD to the ground end VSS.

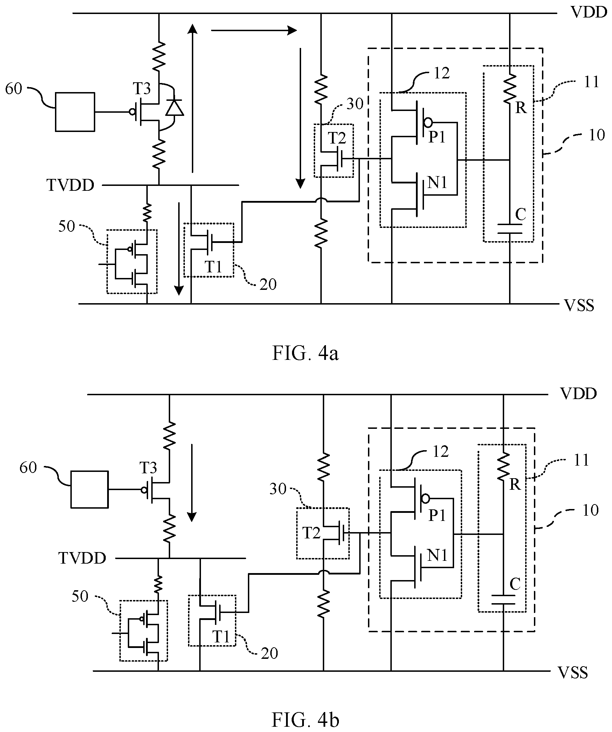

In view of the foregoing problem, embodiments of this application provide an electrostatic discharge protection circuit. As shown in FIG. 4a to FIG. 5b, the electrostatic discharge protection circuit may include a control circuit 10, a first switch 20, and a ground end VSS. The first switch 20 and a protected component 50 are coupled in parallel between a first voltage end TVDD and the ground end. The control circuit 10 is configured to: when detecting that the first voltage end TVDD sends an electrostatic signal to a second voltage end VDD, send a control signal to the first switch 20. The first switch 20 is configured to be turned on under control of the control signal. After the first switch 20 is turned on, the first voltage end TVDD, the first switch 20, and the ground end VSS form a conducting path. In this way, an electrostatic voltage on the first voltage end TVDD may be discharged through the first switch 20, to avoid an extremely high electrostatic voltage on the first voltage end TVDD, and further avoid a case in which the protected component 50 is damaged because of impact on the protected component 50 that is caused by a high peak current formed when the high electrostatic voltage is discharged transiently.

In addition, in this application, the first switch 20 and the protected component 50 are coupled in parallel between the first voltage end TVDD and the ground end VSS. During electrostatic discharge, static electricity on the first voltage end TVDD may be discharged through the conducting path formed by the first voltage end TVDD, the first switch 20, and the ground end VSS. In comparison with a conventional technology, in this application, during the electrostatic discharge, the second voltage end VDD does not need to be passed through, so that an electrostatic discharge path can be shortened, and a parasitic resistance on the electrostatic discharge path can be reduced. In addition, in this application, it may be further controlled that a component other than the first switch 20 is no longer integrated on the conducting path formed by the first voltage end TVDD, the first switch 20, and the ground end VSS. In this way, in comparison with the conventional technology, in this application, a total voltage on a path from the first voltage end TVDD to the ground end VSS is no longer affected by impedance of the another component. The total voltage on the path from the first voltage end TVDD to the ground end VSS can be greatly reduced by reducing the parasitic resistance on the electrostatic discharge path and eliminating impedance impact of the another component, to avoid a case in which the protected component 50 is damaged because the total voltage on the path from the first voltage end TVDD to the ground end VSS is greater than a breakdown voltage threshold.

Based on the foregoing circuit, as shown in FIG. 4a to FIG. 5b, the electrostatic discharge protection circuit may further include a second switch 30. The second switch 30 is coupled between the second voltage end VDD and the ground end VSS. The control circuit 10 is further configured to: when detecting that the first voltage end TVDD sends the electrostatic signal to the second voltage end VDD, send the control signal to the second switch 30. The second switch 30 is configured to be turned on under the control of the control signal. After the second switch 30 is turned on, the first voltage end TVDD, the second voltage end VDD, the second switch 30, and the ground end VSS may form a conducting path. In addition to being discharged through the first switch 20, the electrostatic voltage on the first voltage end TVDD may be further discharged through the second switch 30. The first voltage end TVDD discharges at least a part of the electrostatic voltage through the second switch 30, to reduce a voltage value of the first voltage end TVDD, and avoid leakage of a working voltage through the first switch 20 that is caused because the first switch 20 is turned on by mistake when the voltage of the first voltage end TVDD is extremely high, a power supply supplies the working voltage to the first voltage end TVDD through the second voltage end VDD, and the first voltage end TVDD is powered on extremely quickly.

The following describes in detail a structure and a working principle of the electrostatic discharge protection circuit with reference to accompanying drawings and specific embodiments.

In an embodiment, as shown in FIG. 4a and FIG. 4b, the foregoing first switch 20 includes a first transistor T1, and the second switch 30 includes a second transistor T2. The control circuit 10 includes a detection circuit 11 and a first inverter 12. Both the first transistor T1 and the second transistor T2 are N-type transistors. A first electrode of the first transistor T1 is coupled to a first voltage end TVDD, and a second electrode is coupled to a ground end VSS. A first electrode of the second transistor T2 is coupled to a second voltage end VDD, and a second electrode is coupled to the ground end VSS.

It should be noted herein that the first electrode of the first transistor T1 may be a source, and the second electrode may be a drain electrode. First electrodes of the second transistor T2 and a third transistor T3, a first P-type transistor P1, a first N-type transistor N1, a second P-type transistor P2, and a second N-type transistor N2 that are described in the following may also be sources, and second electrodes may also be drain electrodes. Details are not described in the following again.

The detection circuit 11 may be a resistor-capacitor (RC) circuit. The detection circuit 11 includes a resistor R, a capacitor C, and an output end coupled between the resistor R and the capacitor C. The resistor R is coupled between the second voltage end VDD and the output end of the RC circuit, and the capacitor C is coupled between the ground end VSS and the output end of the RC circuit.

A control end of the first inverter 12 is coupled to the output end of the RC circuit, an input end of the first inverter 12 is separately coupled to the second voltage end VDD and the ground end VSS, and an output end of the first inverter 12 is coupled to gates of the first transistor T1 and the second transistor T2. Specifically, the first inverter 12 may include the first P-type transistor P1 and the first N-type transistor N1. A gate of the first P-type transistor P1 is coupled to the output end of the RC circuit, the first electrode of the first P-type transistor P1 is coupled to the second voltage end VDD, and the second electrode of the first P-type transistor P1 is coupled to the gates of the first transistor T1 and the second transistor T2. A gate of the first N-type transistor N1 is coupled to the output end of the RC circuit, the first electrode of the first N-type transistor N1 is coupled to the ground end VSS, and the second electrode of the first N-type transistor N1 is coupled to the gate of the first transistor T1 and the gate of the second transistor T2.

Based on the circuit structure in this embodiment, an electrostatic discharge protection circuit may work in an electrostatic discharge phase and a normal working phase.

As shown in FIG. 4a, in the electrostatic discharge phase, a chip generates an electric charge due to reasons such as manufacturing, transportation, packaging, or testing. If the chip is in contact with the ground, electrostatic discharge occurs, and an electric charge on the first voltage end TVDD flows to the low electric potential ground end VSS through the second voltage end VDD. The electric charge flows to the second voltage end VDD, and a voltage of the second voltage end VDD is rapidly pulled up. It should be noted herein that, in comparison with a voltage of the ground end VSS, the voltage of the second voltage end VDD and a voltage of the first voltage end TVDD are high electrical levels.

In some possible implementations, the electrostatic discharge protection circuit may further include the third transistor T3. In the electrostatic discharge phase, a gate of the third transistor T3 is floated (in other words, no voltage is applied to the gate of the third transistor T3, or a high electrical level and a low electrical level are not input to the third transistor T3), so that a source, a body end, and a drain electrode of the third transistor T3 may form a diode. The electric charge on the first voltage end TVDD may flow to a low electric potential through the diode. The third transistor T3 may be a P-type transistor.

When detecting that the first voltage end TVDD sends an electrostatic signal to the second voltage end VDD, the RC circuit determines that flowing of the electric charge on the first voltage end TVDD to the second voltage end VDD is an electrostatic discharge event (ESD event). The output end of the RC circuit outputs a detection signal. Because the resistor R is coupled between the second voltage end VDD and the output end of the RC circuit, the resistor R has a delay effect on the high electrical level of the second voltage end VDD, and the detection signal output from the RC circuit is a low electrical level opposite to the high electrical level.

In this embodiment of this application, the RC circuit may identify a rising edge of a pulse of the second voltage end VDD; when the rising edge of the pulse matches a rising edge of a pulse of an electrostatic voltage, determine that flowing of the electric charge on the first voltage end TVDD to the second voltage end VDD is the electrostatic discharge event; and output the detection signal. For example, if the rising edge of the pulse of the electrostatic voltage is at an ns level to a µs level, the RC circuit determines that flowing of the electric charge on the first voltage end TVDD to the second voltage end VDD is the electrostatic discharge event. Certainly, in another scenario, the rising edge of the pulse of the electrostatic voltage may be further in another time range. This is not limited in this embodiment of this application, provided that a manner in which the RC circuit identifies the electrostatic voltage is preset. In other words, when the RC circuit detects that the first voltage end TVDD sends the electrostatic signal to the second voltage end VDD, the level of the second voltage end VDD rises rapidly, and a voltage on the RC circuit increases.

Then, the low electrical level output from the RC circuit may be transmitted to the gate of the first P-type transistor P1 and the gate of the first N-type transistor N1, and is used as an enable signal of the first P-type transistor P1 and the first N-type transistor N1. Under control of the low electrical level, the first P-type transistor P1 is turned on, and the first N-type transistor N1 is switched off. After being turned on, the first P-type transistor P1 may send a control signal to the first transistor T1 and the second transistor T2. In other words, the first electrode of the first P-type transistor P1 sends the high electrical level of the second voltage end VDD to the gate of the first transistor T1 and the gate of the second transistor T2 through the second electrode of the first P-type transistor P1.

Because the first transistor T1 and the second transistor T2 are the N-type transistors, the first transistor T1 and the second transistor T2 are turned on under control of the high electrical level. An electrostatic voltage on the first voltage end TVDD may be discharged to the ground end VSS through the first transistor T1 and the second transistor T2 separately.

It should be noted herein that, even if an electrostatic discharge effect of the second transistor T2 is not good because impedance between the first voltage end TVDD and the second voltage end VDD is high, discharge of the electrostatic voltage on the first voltage end TVDD to the ground end VSS through the first transistor T1 is not affected. In addition, although the first voltage end TVDD may further indirectly control the first transistor T1 to be turned on, at least a part of the electrostatic voltage may be discharged through the second transistor T2. Therefore, even if the first voltage end TVDD is powered on extremely quickly, the first switch 20 is not turned on by mistake. This avoids leakage of a working voltage of the first voltage end TVDD through the first switch 20.

As shown in FIG. 4b, in the normal working phase, the second voltage end VDD may be coupled to a power supply, and the power supply inputs the working voltage to the first voltage end TVDD through the second voltage end VDD, so that a protected component 50 normally works between the first voltage end TVDD and the ground end VSS.

In some possible implementations, the electrostatic discharge protection circuit may further include a drive circuit 60. In the normal working phase, the drive circuit 60 may provide a low electrical level to the gate of the third transistor T3, to enable the third transistor T3 to be turned on. Further, the second voltage end VDD may send the working voltage to the first voltage end TVDD through the third transistor T3.

In addition, in the normal working phase, if an electrostatic voltage exists in another circuit in the chip except a protected circuit 200, and the electrostatic voltage is transmitted to the second voltage end VDD and the first voltage end TVDD through the power supply, once the RC circuit determines that flowing of an electric charge to the second voltage end VDD through the power supply is an electrostatic discharge event, the RC circuit may also output a low electrical level to the first inverter 12, to enable the first P-type transistor P1 to be turned on. The first P-type transistor P1 sends the high electrical level of the second voltage end VDD to the gate of the first transistor T1, to enable the first transistor T1 to be turned on. In this way, the electrostatic voltage transmitted from the power supply to the first voltage end TVDD is discharged to the ground end VSS through the first transistor T1.

In this case, because the first transistor T1 is connected in parallel to the protected component 50, when the electrostatic voltage transmitted from the power supply to the first voltage end TVDD is discharged through the first transistor T1, normal working of the protected circuit 200 is not affected. In addition, because the first voltage end TVDD discharges the electrostatic voltage through the first transistor T1, a case in which the protected component 50 is damaged because a total voltage on a path from the first voltage end TVDD to the ground end VSS is high, in other words, a clamping voltage between the first voltage end TVDD and the ground end VSS is high may be further avoided.

In addition, it should be noted that, in this embodiment, an example in which the electrostatic discharge protection circuit includes the first switch 20 and the second switch 30 is used to describe a working principle of the electrostatic discharge protection circuit. However, when the electrostatic discharge protection circuit includes the first switch 20 but does not include the second switch 30, the control circuit 10 may include the RC circuit and the first inverter 12, and a connection relationship between the RC circuit and the first inverter 12 and working principles of the RC circuit and the first inverter 12 are the same as those in this embodiment. Details are not described herein again.

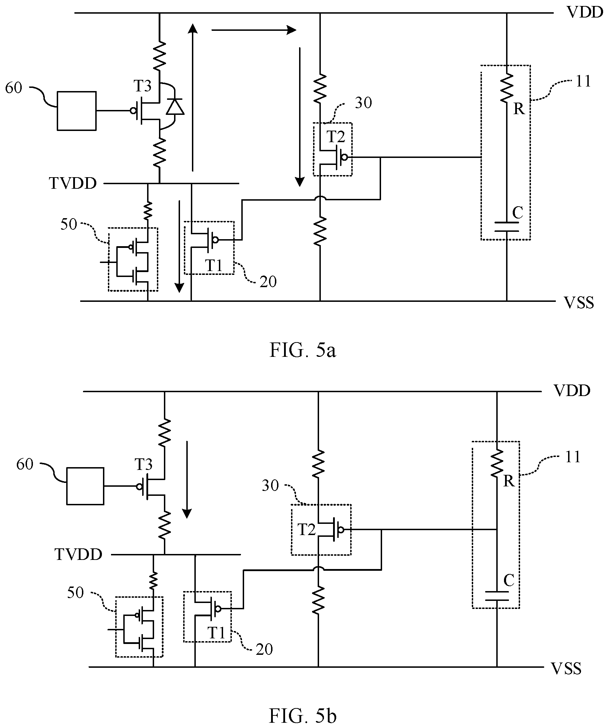

In another embodiment, as shown in FIG. 5a and FIG. 5b, when a control circuit 10 does not include a first inverter 12 (or a control circuit does not include a first inverter and a second inverter in the following), in this embodiment of this application, a first transistor T1 and a second transistor T2 may be P-type transistors, and gates of the first transistor T1 and the second transistor T2 may be coupled to an output end of an RC circuit. In addition, other circuit structures in the solutions shown in FIG. 5a and FIG. 5b are the same as other circuit structures in the solutions shown in FIG. 4a and FIG. 4b.

Based on the circuit structure in this embodiment, an electrostatic discharge protection circuit may work in an electrostatic discharge phase and a normal working phase.

As shown in FIG. 5a, in the electrostatic discharge phase, a chip generates an electric charge due to reasons such as manufacturing, transportation, packaging, or testing. If the chip is in contact with the ground, electrostatic discharge occurs, and an electric charge on the first voltage end TVDD flows to a low electric potential ground end VSS through a second voltage end VDD. The electric charge flows to the second voltage end VDD, and a voltage of the second voltage end VDD is rapidly pulled up. It should be noted herein that, in comparison with a voltage of the ground end VSS, the voltage of the second voltage end VDD and a voltage of the first voltage end TVDD are high electrical levels.

In some possible implementations, the electrostatic discharge protection circuit may further include a third transistor T3. In the electrostatic discharge phase, a gate of the third transistor T3 is floated (in other words, no voltage is applied to the gate of the third transistor T3, or a high electrical level and a low electrical level are not input to the third transistor T3), so that a source, a body end, and a drain electrode of the third transistor T3 may form a diode. The electric charge on the first voltage end TVDD may flow to a low electric potential through the diode. The third transistor T3 may be a P-type transistor.

When detecting that the first voltage end TVDD sends an electrostatic signal to the second voltage end VDD, the RC circuit determines that flowing of the electric charge on the first voltage end TVDD to the second voltage end VDD is an electrostatic discharge event (ESD event). The output end of the RC circuit outputs a detection signal. Because a resistor R is coupled between the second voltage end VDD and the output end of the RC circuit, the resistor R has a delay effect on the high electrical level of the second voltage end VDD, and the detection signal output from the RC circuit is a low electrical level opposite to the high electrical level.

In this embodiment of this application, the RC circuit may identify a rising edge of a pulse of the second voltage end VDD; when the rising edge of the pulse matches a rising edge of a pulse of an electrostatic voltage, determine that flowing of the electric charge on the first voltage end TVDD to the second voltage end VDD is the electrostatic discharge event; and output the detection signal, where the detection signal may be used as a control signal. For example, if the rising edge of the pulse of the electrostatic voltage is at an ns level to a µs level, the RC circuit determines that flowing of the electric charge on the first voltage end TVDD to the second voltage end VDD is the electrostatic discharge event. Certainly, in another scenario, the rising edge of the pulse of the electrostatic voltage may be further in another time range. This is not limited in this embodiment of this application, provided that a manner in which the RC circuit identifies the electrostatic voltage is preset. In other words, when the RC circuit detects that the first voltage end TVDD sends the electrostatic signal to the second voltage end VDD, the level of the second voltage end VDD rises rapidly, and a voltage on the RC circuit increases.

Then, the low electrical level output from the RC circuit may be transmitted to the gates of the first transistor T1 and the second transistor T2. Because the first transistor T1 and the second transistor T2 are the P-type transistors, the first transistor T1 and the second transistor T2 are turned on under control of the low electrical level. An electrostatic voltage on the first voltage end TVDD may be discharged to the ground end VSS through the first transistor T1 and the second transistor T2 separately.

It should be noted herein that, even if an electrostatic discharge effect of the second transistor T2 is not good because impedance between the first voltage end TVDD and the second voltage end VDD is high, discharge of the electrostatic voltage on the first voltage end TVDD to the ground end VSS through the first transistor T1 is not affected. In addition, although the first voltage end TVDD may further indirectly control the first transistor T1 to be turned on, at least a part of the electrostatic voltage may be discharged through the second transistor T2. Therefore, even if the first voltage end TVDD is powered on extremely quickly, a first switch 20 is not turned on by mistake. This avoids leakage of a working voltage of the first voltage end TVDD through the first switch 20.

In addition, in comparison with the foregoing solution that is shown in FIG. 4a and in which the control circuit 10 includes the first inverter 12, in this embodiment of this application, a layout area of the electrostatic discharge protection circuit can be reduced. However, the foregoing solution in which the control circuit 10 includes the first inverter 12 may be applied to a scenario in which paths from the RC circuit to the gate of the first transistor T1 and the gate of the second transistor T2 are extremely long. This avoids a case in which the first transistor T1 and the second transistor T2 cannot be fully turned on because a signal output from the RC circuit is consumed on the path due to the extremely long paths from the RC circuit to the gate of the first transistor T1 and the gate of the second transistor T2.

As shown in FIG. 5b, in the normal working phase, the second voltage end VDD may be coupled to a power supply, and the power supply inputs the working voltage to the first voltage end TVDD through the second voltage end VDD, so that a protected component 50 normally works between the first voltage end TVDD and the ground end VSS.

In some possible implementations, the electrostatic discharge protection circuit may further include a drive circuit 60. In the normal working phase, the drive circuit 60 may provide a low electrical level to the gate of the third transistor T3, to enable the third transistor T3 to be turned on. Further, the second voltage end VDD may send the working voltage to the first voltage end TVDD through the third transistor T3.

In addition, in the normal working phase, if an electrostatic voltage exists in another circuit in the chip except a protected circuit 200, and the electrostatic voltage is transmitted to the second voltage end VDD and the first voltage end TVDD through the power supply, once the RC circuit determines that flowing of an electric charge to the second voltage end VDD through the power supply is an electrostatic discharge event, the RC circuit may also output a low electrical level to the first transistor T1, to enable the first transistor T1 to be turned on. In this way, the electrostatic voltage transmitted from the power supply to the first voltage end TVDD is discharged to the ground end VSS through the first transistor T1.

In this case, because the first transistor T1 is connected in parallel to the protected component 50, when the electrostatic voltage transmitted from the power supply to the first voltage end TVDD is discharged through the first transistor T1, normal working of the protected circuit 200 is not affected. In addition, because the first voltage end TVDD discharges the electrostatic voltage through the first transistor T1, a case in which the protected component 50 is damaged because a total voltage on a path from the first voltage end TVDD to the ground end VSS is high, in other words, a clamping voltage between the first voltage end TVDD and the ground end VSS is high may be further avoided.

In addition, it should be noted that, in this embodiment, an example in which the electrostatic discharge protection circuit includes the first switch 20 and a second switch 30 is used to describe a working principle of the electrostatic discharge protection circuit. However, when the electrostatic discharge protection circuit includes the first switch 20 but does not include the second switch 30, the control circuit 10 may include the RC circuit and the first inverter 12, and a connection relationship between the RC circuit and the first inverter 12 and working principles of the RC circuit and the first inverter 12 are the same as those in this embodiment. Details are not described herein again.

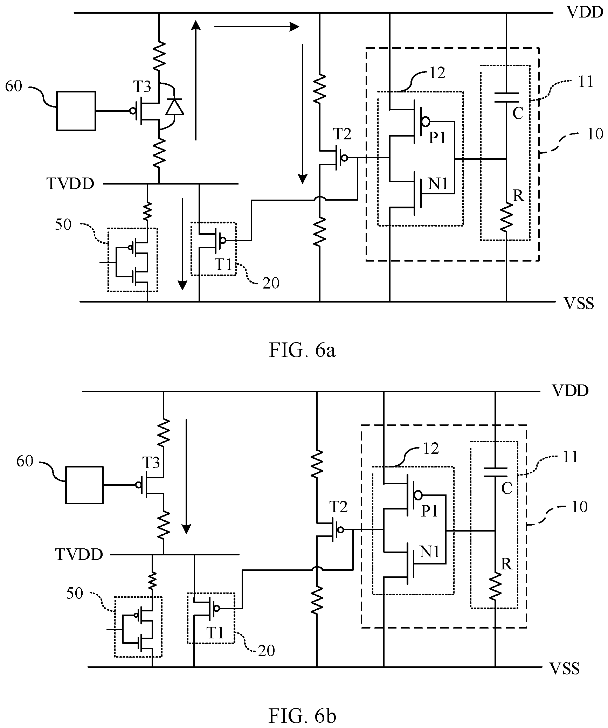

In still another embodiment, as shown in FIG. 6a and FIG. 6b, the foregoing first switch 20 includes a first transistor T1, and the second switch 30 includes a second transistor T2. The control circuit 10 includes a detection circuit 11 and a first inverter 12. Both the first transistor T1 and the second transistor T2 are P-type transistors. A first electrode of the first transistor T1 is coupled to a first voltage end TVDD, and a second electrode is coupled to a ground end VSS. A first electrode of the second transistor T2 is coupled to a second voltage end VDD, and a second electrode is coupled to the ground end VSS.

The detection circuit 11 may be an RC circuit. The detection circuit 11 includes a resistor R, a capacitor C, and an output end coupled between the resistor R and the capacitor C. The capacitor C is coupled between the second voltage end VDD and the output end of the RC circuit, and the resistor R is coupled between the ground end VSS and the output end of the RC circuit.

A control end of the first inverter 12 is coupled to the output end of the RC circuit, an input end of the first inverter 12 is separately coupled to the second voltage end VDD and the ground end VSS, and an output end of the first inverter 12 is coupled to a gate of the second transistor T2. Specifically, the first inverter 12 may include a first P-type transistor P1 and a first N-type transistor N1. A gate of the first P-type transistor P1 is coupled to the output end of the RC circuit, a first electrode of the first P-type transistor P1 is coupled to the second voltage end VDD, and a second electrode of the first P-type transistor P1 is coupled to gates of the first transistor T1 and the second transistor T2. A gate of the first N-type transistor N1 is coupled to the output end of the RC circuit, a first electrode of the first N-type transistor N1 is coupled to the ground end VSS, and a second electrode of the first N-type transistor N1 is coupled to the gate of the first transistor T1 and the gate of the second transistor T2.

Based on the circuit structure in this embodiment, an electrostatic discharge protection circuit may work in an electrostatic discharge phase and a normal working phase.

As shown in FIG. 6a, in the electrostatic discharge phase, a chip generates an electric charge due to reasons such as manufacturing, transportation, packaging, or testing. If the chip is in contact with the ground, electrostatic discharge occurs, and an electric charge on the first voltage end TVDD flows to a low electric potential. The electric charge flows to the second voltage end VDD, and a voltage of the second voltage end VDD is rapidly pulled up. It should be noted herein that, in comparison with a voltage of the ground end VSS, the voltage of the second voltage end VDD and a voltage of the first voltage end TVDD are high electrical levels.

In some possible implementations, the electrostatic discharge protection circuit may further include a third transistor T3. In the electrostatic discharge phase, a gate of the third transistor T3 is floated (in other words, no voltage is applied to the gate of the third transistor T3, or a high electrical level and a low electrical level are not input to the third transistor T3), so that a source, a body end, and a drain electrode of the third transistor T3 may form a diode. The electric charge on the first voltage end TVDD may flow to the low electric potential through the diode.

When detecting that the first voltage end TVDD sends an electrostatic signal to the second voltage end VDD, the RC circuit determines that flowing of the electric charge on the first voltage end TVDD to the second voltage end VDD is an electrostatic discharge event. The output end of the RC circuit outputs a detection signal. Because the capacitor C is coupled between the second voltage end VDD and the output end of the RC circuit, the capacitor C has no delay effect on the high electrical level of the second voltage end VDD, and the high electrical level of the second voltage end VDD may pull up the output end of the RC circuit through the capacitor C. Therefore, the detection signal output from the RC circuit is also a high electrical level.

In this embodiment of this application, the RC circuit may identify a rising edge of a pulse of the second voltage end VDD; when the rising edge of the pulse matches a rising edge of a pulse of an electrostatic voltage, determine that flowing of the electric charge on the first voltage end TVDD to the second voltage end VDD is the electrostatic discharge event; and output the detection signal. For example, if the rising edge of the pulse of the electrostatic voltage is at an ns level to a µs level, the RC circuit determines that flowing of the electric charge on the first voltage end TVDD to the second voltage end VDD is the electrostatic discharge event. Certainly, in another scenario, the rising edge of the pulse of the electrostatic voltage may be further in another time range. This is not limited in this embodiment of this application, provided that a manner in which the RC circuit identifies the electrostatic voltage is preset. In other words, when the RC circuit detects that the first voltage end TVDD sends the electrostatic signal to the second voltage end VDD, the level of the second voltage end VDD rises rapidly, and a voltage on the RC circuit increases.

Then, the high electrical level output from the RC circuit may be transmitted to the gate of the first P-type transistor P1 and the gate of the first N-type transistor N1, and is used as an enable signal of the first P-type transistor P1 and the first N-type transistor N1. Under control of the high electrical level, the first N-type transistor N1 is turned on, and the first P-type transistor P1 is switched off. After being turned on, the first N-type transistor N1 may send a control signal to the first transistor T1 and the second transistor T2. In other words, the first electrode of the first N-type transistor N1 sends a low electrical level of the ground end VSS to the gate of the first transistor T1 and the gate of the second transistor T2 through the second electrode of the first N-type transistor N1.

Because the first transistor T1 and the second transistor T2 are the P-type transistors, the first transistor T1 and the second transistor T2 are turned on under control of the low electrical level. An electrostatic voltage on the first voltage end TVDD may be discharged to the ground end VSS through the first transistor T1 and the second transistor T2 separately.

It should be noted herein that, even if an electrostatic discharge effect of the second transistor T2 is not good because impedance between the first voltage end TVDD and the second voltage end VDD is high, discharge of the electrostatic voltage on the first voltage end TVDD to the ground end VSS through the first transistor T1 is not affected. In addition, although the first voltage end TVDD may further indirectly control the first transistor T1 to be turned on, at least a part of the electrostatic voltage may be discharged through the second transistor T2. Therefore, even if the first voltage end TVDD is powered on extremely quickly, the first switch 20 is not turned on by mistake. This avoids leakage of a working voltage of the first voltage end TVDD through the first switch 20.

As shown in FIG. 6b, in the normal working phase, the second voltage end VDD may be coupled to a power supply, and the power supply inputs the working voltage to the first voltage end TVDD through the second voltage end VDD, so that a protected component 50 normally works between the first voltage end TVDD and the ground end VSS.

In some possible implementations, the electrostatic discharge protection circuit may further include a drive circuit 60. In the normal working phase, the drive circuit 60 may provide a low electrical level to the gate of the third transistor T3, to enable the third transistor T3 to be turned on. Further, the second voltage end VDD may send the working voltage to the first voltage end TVDD through the third transistor T3.

In addition, in the normal working phase, if an electrostatic voltage exists in another circuit in the chip except a protected circuit 200, and the electrostatic voltage is transmitted to the second voltage end VDD and the first voltage end TVDD through the power supply, once the RC circuit determines that flowing of an electric charge to the second voltage end VDD through the power supply is an electrostatic discharge event, the RC circuit may also output a high electrical level to the first inverter, to enable the first N-type transistor 1 to be turned on. The first N-type transistor N1 sends the low electrical level of the ground end VSS to the gate of the first transistor T1, to enable the first transistor T1 to be turned on. In this way, the electrostatic voltage transmitted from the power supply to the first voltage end TVDD is discharged to the ground end VSS through the first transistor T1.

In this case, because the first transistor T1 is connected in parallel to the protected component 50, when the electrostatic voltage transmitted from the power supply to the first voltage end TVDD is discharged through the first transistor T1, normal working of the protected circuit 200 is not affected. In addition, because the first voltage end TVDD discharges the electrostatic voltage through the first transistor T1, a case in which the protected component 50 is damaged because a total voltage on a path from the first voltage end TVDD to the ground end VSS is high, in other words, a clamping voltage between the first voltage end TVDD and the ground end VSS is high may be further avoided.

In addition, it should be noted that, in this embodiment, an example in which the electrostatic discharge protection circuit includes the first switch 20 and the second switch 30 is used to describe a working principle of the electrostatic discharge protection circuit. However, when the electrostatic discharge protection circuit includes the first switch 20 but does not include the second switch 30, the control circuit 10 may include the RC circuit and the first inverter 12, and a connection relationship between the RC circuit and the first inverter 12 and working principles of the RC circuit and the first inverter 12 are the same as those in this embodiment. Details are not described herein again.

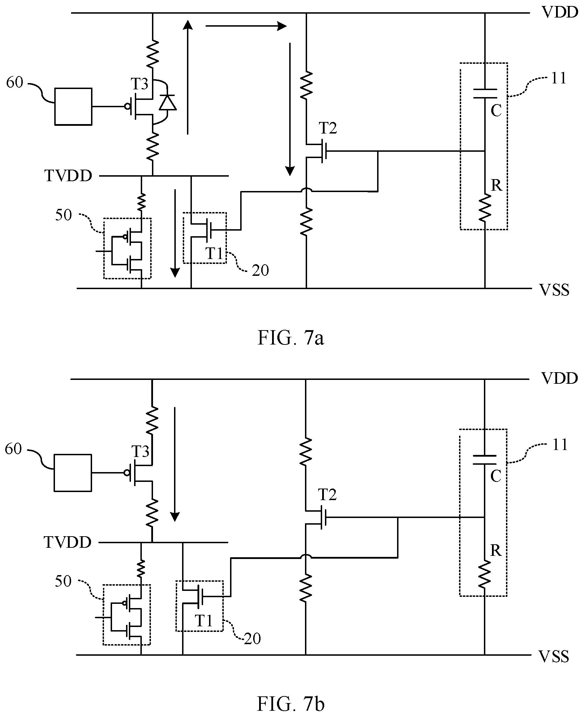

In still another embodiment, as shown in FIG. 7a and FIG. 7b, when a control circuit does not include a first inverter 12 (or a control circuit does not include a first inverter and a second inverter in the following), in this embodiment of this application, a first transistor T1 and a second transistor T2 may be N-type transistors, and gates of the first transistor T1 and the second transistor T2 may be coupled to an output end of an RC circuit. In addition, other circuit structures in the solutions shown in FIG. 7a and FIG. 7b are the same as other circuit structures in the solutions shown in FIG. 6a and FIG. 6b.

Based on the circuit structure in this embodiment, an electrostatic discharge protection circuit may work in an electrostatic discharge phase and a normal working phase.

As shown in FIG. 7a, in the electrostatic discharge phase, a chip generates an electric charge due to reasons such as manufacturing, transportation, packaging, or testing. If the chip is in contact with the ground, electrostatic discharge occurs, and an electric charge on a first voltage end TVDD flows to a low electric potential. The electric charge flows to a second voltage end VDD, and a voltage of the second voltage end VDD is rapidly pulled up. It should be noted herein that, in comparison with a voltage of a ground end VSS, the voltage of the second voltage end VDD and a voltage of the first voltage end TVDD are high electrical levels.

In some possible implementations, the electrostatic discharge protection circuit may further include a third transistor T3. In the electrostatic discharge phase, a gate of the third transistor T3 is floated (in other words, no voltage is applied to the gate of the third transistor T3, or a high electrical level and a low electrical level are not input to the third transistor T3), so that a source, a body end, and a drain electrode of the third transistor T3 may form a diode. The electric charge on the first voltage end TVDD may flow to the low electric potential through the diode.

When detecting that the first voltage end TVDD sends an electrostatic signal to the second voltage end VDD, the RC circuit determines that flowing of the electric charge on the first voltage end TVDD to the second voltage end VDD is an electrostatic discharge event. The output end of the RC circuit outputs a detection signal. Because a capacitor C is coupled between the second voltage end VDD and the output end of the RC circuit, the capacitor C has no delay effect on the high electrical level of the second voltage end VDD, and the high electrical level of the second voltage end VDD may pull up the output end of the RC circuit through the capacitor C. Therefore, the detection signal output from the RC circuit is also a high electrical level.

In this embodiment of this application, the RC circuit may identify a rising edge of a pulse of the second voltage end VDD; when the rising edge of the pulse matches a rising edge of a pulse of an electrostatic voltage, determine that flowing of the electric charge on the first voltage end TVDD to the second voltage end VDD is the electrostatic discharge event; and output the detection signal, where the detection signal may be used as a control signal. For example, if the rising edge of the pulse of the electrostatic voltage is at an ns level to a µs level, the RC circuit determines that flowing of the electric charge on the first voltage end TVDD to the second voltage end VDD is the electrostatic discharge event. Certainly, in another scenario, the rising edge of the pulse of the electrostatic voltage may be further in another time range. This is not limited in this embodiment of this application, provided that a manner in which the RC circuit identifies the electrostatic voltage is preset. In other words, when the RC circuit detects that the first voltage end TVDD sends the electrostatic signal to the second voltage end VDD, the level of the second voltage end VDD rises rapidly, and a voltage on the RC circuit increases.

Then, the high electrical level output from the RC circuit may be transmitted to the gates of the first transistor T1 and the second transistor T2. Because the first transistor T1 and the second transistor T2 are the N-type transistors, the first transistor T1 and the second transistor T2 are turned on under control of the high electrical level. An electrostatic voltage on the first voltage end TVDD may be discharged to the ground end VSS through the first transistor T1 and the second transistor T2 separately.

It should be noted herein that, even if an electrostatic discharge effect of the second transistor T2 is not good because impedance between the first voltage end TVDD and the second voltage end VDD is high, discharge of the electrostatic voltage on the first voltage end TVDD to the ground end VSS through the first transistor T1 is not affected. In addition, although the first voltage end TVDD may further indirectly control the first transistor T1 to be turned on, at least a part of the electrostatic voltage may be discharged through the second transistor T2. Therefore, even if the first voltage end TVDD is powered on extremely quickly, a first switch 20 is not turned on by mistake. This avoids leakage of a working voltage of the first voltage end TVDD through the first switch 20.

In addition, in comparison with the foregoing solution that is shown in FIG. 6a and in which the control circuit 10 includes the first inverter 12, in this embodiment of this application, a layout area of the electrostatic discharge protection circuit can be reduced. However, the foregoing solution in which the control circuit 10 includes the first inverter 12 may be applied to a scenario in which paths from the RC circuit to the gate of the first transistor T1 and the gate of the second transistor T2 are extremely long. This avoids a case in which the first transistor T1 and the second transistor T2 cannot be fully turned on because a signal output from the RC circuit is consumed on the path due to the extremely long paths from the RC circuit to the gate of the first transistor T1 and the gate of the second transistor T2.

As shown in FIG. 7b, in the normal working phase, the second voltage end VDD may be coupled to a power supply, and the power supply inputs the working voltage to the first voltage end TVDD through the second voltage end VDD, so that a protected component 50 normally works between the first voltage end TVDD and the ground end VSS.

In some possible implementations, the electrostatic discharge protection circuit may further include a drive circuit 60. In the normal working phase, the drive circuit 60 may provide a low electrical level to the gate of the third transistor T3, to enable the third transistor T3 to be turned on. Further, the second voltage end VDD may send the working voltage to the first voltage end TVDD through the third transistor T3.

In addition, in the normal working phase, if an electrostatic voltage exists in another circuit in the chip except a protected circuit 200, and the electrostatic voltage is transmitted to the second voltage end VDD and the first voltage end TVDD through the power supply, once the RC circuit determines that flowing of an electric charge to the second voltage end VDD through the power supply is an electrostatic discharge event, the RC circuit may also output a low electrical level to the first transistor T1, to enable the first transistor T1 to be turned on. In this way, the electrostatic voltage transmitted from the power supply to the first voltage end TVDD is discharged to the ground end VSS through the first transistor T1.

In this case, because the first transistor T1 is connected in parallel to the protected component 50, when the electrostatic voltage transmitted from the power supply to the first voltage end TVDD is discharged through the first transistor T1, normal working of the protected circuit 200 is not affected. In addition, because the first voltage end TVDD discharges the electrostatic voltage through the first transistor T1, a case in which the protected component 50 is damaged because a total voltage on a path from the first voltage end TVDD to the ground end VSS is high, in other words, a clamping voltage between the first voltage end TVDD and the ground end VSS is high may be further avoided.

In addition, it should be noted that, in this embodiment, an example in which the electrostatic discharge protection circuit includes the first switch 20 and a second switch 30 is used to describe a working principle of the electrostatic discharge protection circuit. However, when the electrostatic discharge protection circuit includes the first switch 20 but does not include the second switch 30, the control circuit 10 may include the RC circuit and the first inverter 12, and a connection relationship between the RC circuit and the first inverter 12 and working principles of the RC circuit and the first inverter 12 are the same as those in this embodiment. Details are not described herein again.

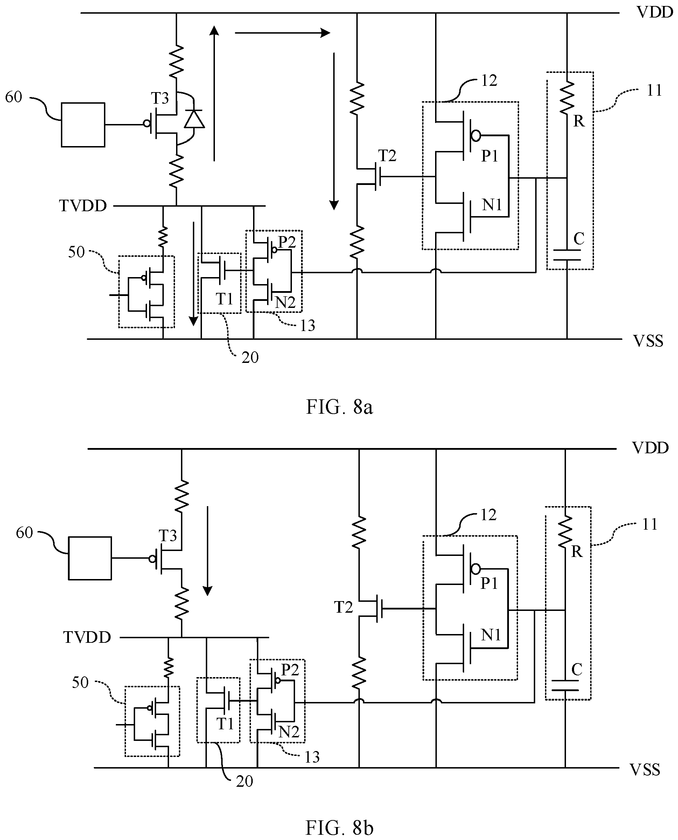

In still another embodiment, as shown in FIG. 8a and FIG. 8b, the foregoing first switch 20 includes a first transistor T1, and the second switch 30 includes a second transistor T2. The control circuit 10 includes a detection circuit 11, a first inverter 12, and a second inverter 13. Both the first transistor T1 and the second transistor T2 are N-type transistors. A first electrode of the first transistor T1 is coupled to a first voltage end TVDD, and a second electrode is coupled to a ground end VSS. A first electrode of the second transistor T2 is coupled to a second voltage end VDD, and a second electrode is coupled to the ground end VSS.

The detection circuit 11 may be an RC circuit. The detection circuit 11 includes a resistor R and a capacitor C. The resistor R is coupled between the second voltage end VDD and an output end of the RC circuit, and the capacitor C is coupled between the ground end VSS and the output end of the RC circuit.

A control end of the first inverter 12 is coupled to the output end of the RC circuit, an input end of the first inverter 12 is separately coupled to the second voltage end VDD and the ground end VSS, and an output end of the first inverter 12 is coupled to a gate of the second transistor T2. Specifically, the first inverter 12 may include a first P-type transistor P1 and a first N-type transistor N1. A gate of the first P-type transistor P1 is coupled to the output end of the RC circuit, a first electrode of the first P-type transistor P1 is coupled to the second voltage end VDD, and a second electrode of the first P-type transistor P1 is coupled to the gate of the second transistor T2. A gate of the first N-type transistor N1 is coupled to the output end of the RC circuit, a first electrode of the first N-type transistor N1 is coupled to the ground end VSS, and a second electrode of the first N-type transistor N1 is coupled to the gate of the second transistor T2.

A control end of the second inverter 13 is coupled to the output end of the RC circuit, an input end of the second inverter 13 is separately coupled to the first voltage end TVDD and the ground end VSS, and an output end of the second inverter 13 is coupled to a gate of the first transistor T1. Specifically, the second inverter 13 may include a second P-type transistor P2 and a second N-type transistor N2. A gate of the second P-type transistor P2 is coupled to the output end of the RC circuit, a first electrode of the second P-type transistor P2 is coupled to the first voltage end TVDD, and a second electrode of the second P-type transistor P2 is coupled to the gate of the first transistor T1. A gate of the second N-type transistor N2 is coupled to the output end of the RC circuit, a first electrode of the second N-type transistor N2 is coupled to the ground end VSS, and a second electrode of the second N-type transistor N2 is coupled to the gate of the first transistor T1.

Based on the circuit structure in this embodiment, an electrostatic discharge protection circuit may work in an electrostatic discharge phase and a normal working phase.

As shown in FIG. 8a, in the electrostatic discharge phase, a chip generates an electric charge due to reasons such as manufacturing, transportation, packaging, or testing. If the chip is in contact with the ground, electrostatic discharge occurs, and an electric charge on the first voltage end TVDD flows to a low electric potential through the second voltage end VDD. The electric charge flows to the second voltage end VDD, and a voltage of the second voltage end VDD is rapidly pulled up. It should be noted herein that, in comparison with a voltage of the ground end VSS, the voltage of the second voltage end VDD and a voltage of the first voltage end TVDD are high electrical levels.

In some possible implementations, the electrostatic discharge protection circuit may further include a third transistor T3. In the electrostatic discharge phase, a gate of the third transistor T3 is floated (in other words, no voltage is applied to the gate of the third transistor T3, or a high electrical level and a low electrical level are not input to the third transistor T3), so that a source, a body end, and a drain electrode of the third transistor T3 may form a diode. The electric charge on the first voltage end TVDD may flow to the low electric potential through the diode. The third transistor T3 may be a P-type transistor.

When detecting that the first voltage end TVDD sends an electrostatic signal to the second voltage end VDD, the RC circuit determines that flowing of the electric charge on the first voltage end TVDD to the second voltage end VDD is an electrostatic discharge event. The output end of the RC circuit outputs a detection signal. Because the resistor R is coupled between the second voltage end VDD and the output end of the RC circuit, the resistor R has a delay effect on the high electrical level of the second voltage end VDD, and the detection signal output from the RC circuit is a low electrical level opposite to the high electrical level.

In this embodiment of this application, the RC circuit may identify a rising edge of a pulse of the second voltage end VDD; when the rising edge of the pulse matches a rising edge of a pulse of an electrostatic voltage, determine that flowing of the electric charge on the first voltage end TVDD to the second voltage end VDD is the electrostatic discharge event; and output the detection signal. For example, if the rising edge of the pulse of the electrostatic voltage is at an ns level to a µs level, the RC circuit determines that flowing of the electric charge on the first voltage end TVDD to the second voltage end VDD is the electrostatic discharge event. Certainly, in another scenario, the rising edge of the pulse of the electrostatic voltage may be further in another time range. This is not limited in this embodiment of this application, provided that a manner in which the RC circuit identifies the electrostatic voltage is preset. In other words, when the RC circuit detects that the first voltage end TVDD sends the electrostatic signal to the second voltage end VDD, the level of the second voltage end VDD rises rapidly, and a voltage on the RC circuit increases.

Then, the low electrical level output from the RC circuit may be transmitted to the gate of the first P-type transistor P1, the gate of the first N-type transistor N1, the gate of the second P-type transistor P2, and the gate of the second N-type transistor N2, and is used as an enable signal of the first P-type transistor P1, the first N-type transistor N1, the second P-type transistor P2, and the second N-type transistor N2. Under control of the low electrical level, the first P-type transistor P1 and the second P-type transistor P2 are turned on, and the first N-type transistor N1 and the second N-type transistor N2 are switched off. After being turned on, the first P-type transistor P1 may send a control signal to the first transistor T1 and the second transistor T2. In other words, the first electrode of the first P-type transistor P1 sends the high electrical level of the second voltage end VDD to the gate of the second transistor T2 through the second electrode of the first P-type transistor P1. After being turned on, the second P-type transistor P2 may send a control signal to the first transistor T1 and the second transistor T2. In other words, the first electrode of the second P-type transistor P2 sends the high electrical level of the first voltage end TVDD to the gate of the first transistor T1 through the second electrode of the second P-type transistor P2.

Because the first transistor T1 and the second transistor T2 are the N-type transistors, the first transistor T1 and the second transistor T2 are turned on under control of the high electrical level. An electrostatic voltage on the first voltage end TVDD may be discharged to the ground end VSS through the first transistor T1 and the second transistor T2 separately.

It should be noted herein that, even if an electrostatic discharge effect of the second transistor T2 is not good because impedance between the first voltage end TVDD and the second voltage end VDD is high, discharge of the electrostatic voltage on the first voltage end TVDD to the ground end VSS through the first transistor T1 is not affected. In addition, although the first voltage end TVDD may further indirectly control the first transistor T1 to be turned on, at least a part of the electrostatic voltage may be discharged through the second transistor T2. Therefore, even if the first voltage end TVDD is powered on extremely quickly, the first switch 20 is not turned on by mistake. This avoids leakage of a working voltage of the first voltage end TVDD through the first switch 20.

In addition, the first P-type transistor P1 of the first inverter 12 and the second P-type transistor P2 of the second inverter 13 have channel impedance when being turned on. For the solution in which the control circuit 10 shown in FIG. 4a does not include the second inverter 13, the first P-type transistor P1 is coupled to the gate of the first transistor T1 through a long path. Consequently, channel impedance reaching the gate of the first transistor T1 further increases. After the first P-type transistor P1 transmits the voltage of the second voltage end VDD to the first transistor T1, a part of the voltage needs to be distributed to the gate of the first transistor T1. As a result, a voltage that is transmitted to the gate of the first transistor T1 and that is used to turn on the first transistor T1 is reduced, and the first transistor T1 is not fully turned on, in other words, the first transistor T1 is weakly turned on. This leads to low efficiency of the electrostatic discharge from the first voltage end TVDD through the first transistor T1.

However, for the solution in which the control circuit 10 in this embodiment includes the second inverter 13, the RC circuit may directly send the low electrical level to the gate of the second P-type transistor P2. Although the second P-type transistor P2 also has channel impedance, a path through which the second P-type transistor P2 is coupled to the gate of the first transistor T1 is short, and after the second P-type transistor P2 transmits the voltage of the first voltage end TVDD to the first transistor T1, the voltage distributed to the gate of the first transistor T1 is small, and the first transistor T1 may be fully turned on, in other words, the first transistor T1 is strongly turned on. In this way, efficiency of the electrostatic discharge from the first voltage end TVDD through the first transistor T1 is not affected. Therefore, in comparison with the solution in which the control circuit 10 does not include the second inverter 13, in this embodiment, the efficiency of the electrostatic discharge from the first voltage end TVDD through the first transistor T1 can be improved.

Certainly, in comparison with the solution in which the control circuit 10 in this embodiment includes the second inverter 13, in the solution shown in FIG. 4a, because the control circuit 10 does not include the second inverter 13, a layout area of the electrostatic discharge protection circuit can be reduced.

As shown in FIG. 8b, in the normal working phase, the second voltage end VDD may be coupled to a power supply, and the power supply inputs the working voltage to the first voltage end TVDD through the second voltage end VDD, so that a protected component 50 normally works between the first voltage end TVDD and the ground end VSS.

In some possible implementations, the electrostatic discharge protection circuit may further include a drive circuit 60. In the normal working phase, the drive circuit 60 may provide a low electrical level to the gate of the third transistor T3, to enable the third transistor T3 to be turned on. Further, the second voltage end VDD may send the working voltage to the first voltage end TVDD through the third transistor T3.

In addition, in the normal working phase, if an electrostatic voltage exists in another circuit in the chip except a protected circuit 200, and the electrostatic voltage is transmitted to the second voltage end VDD and the first voltage end TVDD through the power supply, once the RC circuit determines that flowing of an electric charge to the second voltage end VDD through the power supply is an electrostatic discharge event, the RC circuit may also output a low electrical level to the first inverter 12 and the second inverter 13, to enable the second P-type transistor P2 to be turned on. The second P-type transistor P2 sends the high electrical level of the first voltage end TVDD to the gate of the first transistor T1, to enable the first transistor T1 to be turned on. In this way, the electrostatic voltage transmitted from the power supply to the first voltage end TVDD is discharged to the ground end VSS through the first transistor T1.

In this case, because the first transistor T1 is connected in parallel to the protected component 50, when the electrostatic voltage transmitted from the power supply to the first voltage end TVDD is discharged through the first transistor T1, normal working of the protected circuit 200 is not affected. In addition, because the first voltage end TVDD discharges the electrostatic voltage through the first transistor T1, a case in which the protected component 50 is damaged because a total voltage on a path from the first voltage end TVDD to the ground end VSS is high, in other words, a clamping voltage between the first voltage end TVDD and the ground end VSS is high may be further avoided.

In addition, it should be noted that, in this embodiment, an example in which the electrostatic discharge protection circuit includes the first switch 20 and the second switch 30 is used to describe a working principle of the electrostatic discharge protection circuit. However, when the electrostatic discharge protection circuit includes the first switch 20 but does not include the second switch 30, the control circuit 10 may include the RC circuit and the second inverter 13, and a connection relationship between the RC circuit and the second inverter 13 and working principles of the RC circuit and the second inverter 13 are the same as those in this embodiment. Details are not described herein again.

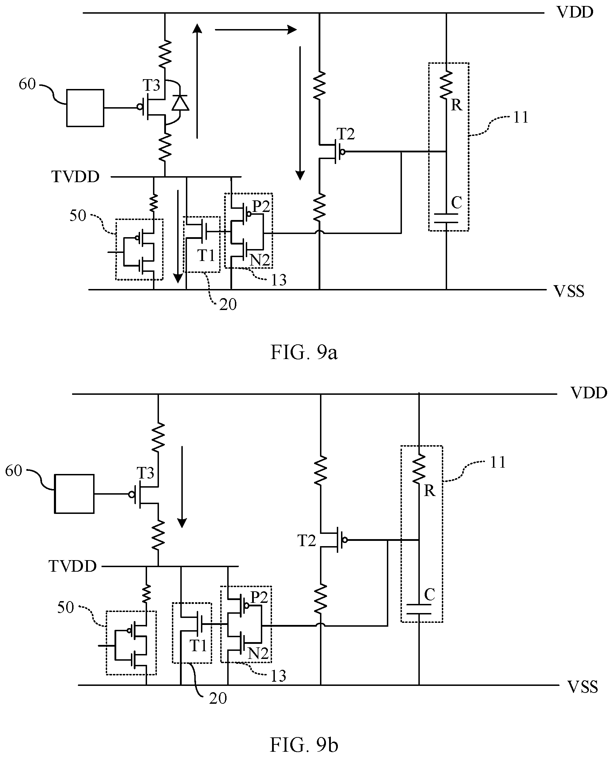

In still another embodiment, as shown in FIG. 9a and FIG. 9b, when a control circuit 10 does not include a first inverter 12 but includes a second inverter 13, in this embodiment of this application, a first transistor T1 may be an N-type transistor, a second transistor T2 may be a P-type transistor, a gate of the first transistor T1 may be coupled to the second inverter 13, and a gate of the second transistor T2 may be coupled to an output end of an RC circuit. In addition, other circuit structures in the solutions shown in FIG. 9a and FIG. 9b are the same as other circuit structures in the solutions shown in FIG. 8a and FIG. 8b.

Based on the circuit structure in this embodiment, an electrostatic discharge protection circuit may work in an electrostatic discharge phase and a normal working phase.

As shown in FIG. 9a, in the electrostatic discharge phase, a chip generates an electric charge due to reasons such as manufacturing, transportation, packaging, or testing. If the chip is in contact with the ground, electrostatic discharge occurs, and an electric charge on a first voltage end TVDD flows to a low electric potential through a second voltage end VDD. The electric charge flows to the second voltage end VDD, and a voltage of the second voltage end VDD is rapidly pulled up. It should be noted herein that, in comparison with a voltage of a ground end VSS, the voltage of the second voltage end VDD and a voltage of the first voltage end TVDD are high electrical levels.

In some possible implementations, the electrostatic discharge protection circuit may further include a third transistor T3. In the electrostatic discharge phase, a gate of the third transistor T3 is floated (in other words, no voltage is applied to the gate of the third transistor T3, or a high electrical level and a low electrical level are not input to the third transistor T3), so that a source, a body end, and a drain electrode of the third transistor T3 may form a diode. The electric charge on the first voltage end TVDD may flow to the low electric potential through the diode. The third transistor T3 may be a P-type transistor.

When detecting that the first voltage end TVDD sends an electrostatic signal to the second voltage end VDD, the RC circuit determines that flowing of the electric charge on the first voltage end TVDD to the second voltage end VDD is an electrostatic discharge event. The output end of the RC circuit outputs a detection signal. Because a resistor R is coupled between the second voltage end VDD and the output end of the RC circuit, the resistor R has a delay effect on the high electrical level of the second voltage end VDD, and the detection signal output from the RC circuit is a low electrical level opposite to the high electrical level.

In this embodiment of this application, the RC circuit may identify a rising edge of a pulse of the second voltage end VDD; when the rising edge of the pulse matches a rising edge of a pulse of an electrostatic voltage, determine that flowing of the electric charge on the first voltage end TVDD to the second voltage end VDD is the electrostatic discharge event; and output the detection signal. For example, if the rising edge of the pulse of the electrostatic voltage is at an ns level to a µs level, the RC circuit determines that flowing of the electric charge on the first voltage end TVDD to the second voltage end VDD is the electrostatic discharge event. Certainly, in another scenario, the rising edge of the pulse of the electrostatic voltage may be further in another time range. This is not limited in this embodiment of this application, provided that a manner in which the RC circuit identifies the electrostatic voltage is preset. In other words, when the RC circuit detects that the first voltage end TVDD sends the electrostatic signal to the second voltage end VDD, the level of the second voltage end VDD rises rapidly, and a voltage on the RC circuit increases.

Then, the low electrical level output from the RC circuit may be transmitted to a gate of a second P-type transistor P2, a gate of a second N-type transistor N2, and the gate of the second transistor T2, and is used as an enable signal of the second P-type transistor P2, the second N-type transistor N2, and the second transistor T2. Under control of the low electrical level, the second P-type transistor P2 and the second transistor T2 are turned on, and the second N-type transistor N2 is switched off. After being turned on, the second P-type transistor P2 may send a control signal to the first transistor T1. In other words, a first electrode of the second P-type transistor P2 sends the high electrical level of the first voltage end TVDD to the gate of the first transistor T1 through a second electrode of the second P-type transistor P2. Because the first transistor T1 is the N-type transistor, the first transistor T1 is turned on under control of the high electrical level. An electrostatic voltage on the first voltage end TVDD may be discharged to the ground end VSS through the first transistor T1 and the second transistor T2 separately.

It should be noted herein that, even if an electrostatic discharge effect of the second transistor T2 is not good because impedance between the first voltage end TVDD and the second voltage end VDD is high, discharge of the electrostatic voltage on the first voltage end TVDD to the ground end VSS through the first transistor T1 is not affected. In addition, although the first voltage end TVDD may further indirectly control the first transistor T1 to be turned on, at least a part of the electrostatic voltage may be discharged through the second transistor T2. Therefore, even if the first voltage end TVDD is powered on extremely quickly, a first switch 20 is not turned on by mistake. This avoids leakage of a working voltage of the first voltage end TVDD through the first switch 20.

For the solution in which the control circuit 10 in this embodiment includes the second inverter 13, the RC circuit may directly send the low electrical level to the gate of the second P-type transistor P2. Although the second P-type transistor P2 also has channel impedance, a path through which the second P-type transistor P2 is coupled to the gate of the first transistor T1 is short, and after the second P-type transistor P2 transmits the voltage of the first voltage end TVDD to the first transistor T1, a voltage distributed to the gate of the first transistor T1 is small, and the first transistor T1 may be fully turned on, in other words, the first transistor T1 is strongly turned on. In this way, efficiency of the electrostatic discharge from the first voltage end TVDD through the first transistor T1 is not affected. Therefore, in comparison with the solution in which the control circuit 10 does not include the second inverter 13, in this embodiment, the efficiency of the electrostatic discharge from the first voltage end TVDD through the first transistor T1 can be improved.

Certainly, in comparison with the solution in which the control circuit 10 in this embodiment includes the second inverter 13, in the solution shown in FIG. 5a, because the control circuit 10 does not include the second inverter 13, a layout area of the electrostatic discharge protection circuit can be reduced.

As shown in FIG. 9b, in the normal working phase, the second voltage end VDD may be coupled to a power supply, and the power supply inputs the working voltage to the first voltage end TVDD through the second voltage end VDD, so that a protected component 50 normally works between the first voltage end TVDD and the ground end VSS.

In some possible implementations, the electrostatic discharge protection circuit may further include a drive circuit 60. In the normal working phase, the drive circuit 60 may provide a low electrical level to the gate of the third transistor T3, to enable the third transistor T3 to be turned on. Further, the second voltage end VDD may send the working voltage to the first voltage end TVDD through the third transistor T3.

In addition, in the normal working phase, if an electrostatic voltage exists in another circuit in the chip except a protected circuit 200, and the electrostatic voltage is transmitted to the second voltage end VDD and the first voltage end TVDD through the power supply, once the RC circuit determines that flowing of an electric charge to the second voltage end VDD through the power supply is an electrostatic discharge event, the RC circuit may also output a low electrical level to the second inverter 13, and input, to the first transistor T1 after the second inverter 13 inverts the low electrical level, a high electrical level obtained through inversion, to enable the first transistor T1 to be turned on. In this way, the electrostatic voltage transmitted from the power supply to the first voltage end TVDD is discharged to the ground end VSS through the first transistor T1.

In this case, because the first transistor T1 is connected in parallel to the protected component 50, when the electrostatic voltage transmitted from the power supply to the first voltage end TVDD is discharged through the first transistor T1, normal working of the protected circuit 200 is not affected. In addition, because the first voltage end TVDD discharges the electrostatic voltage through the first transistor T1, a case in which the protected component 50 is damaged because a total voltage on a path from the first voltage end TVDD to the ground end VSS is high, in other words, a clamping voltage between the first voltage end TVDD and the ground end VSS is high may be further avoided.

In addition, it should be noted that, in this embodiment, an example in which the electrostatic discharge protection circuit includes the first switch 20 and a second switch 30 is used to describe a working principle of the electrostatic discharge protection circuit. However, when the electrostatic discharge protection circuit includes the first switch 20 but does not include the second switch 30, the control circuit 10 may include the RC circuit and the second inverter 13, and a connection relationship between the RC circuit and the second inverter 13 and working principles of the RC circuit and the second inverter 13 are the same as those in this embodiment. Details are not described herein again.

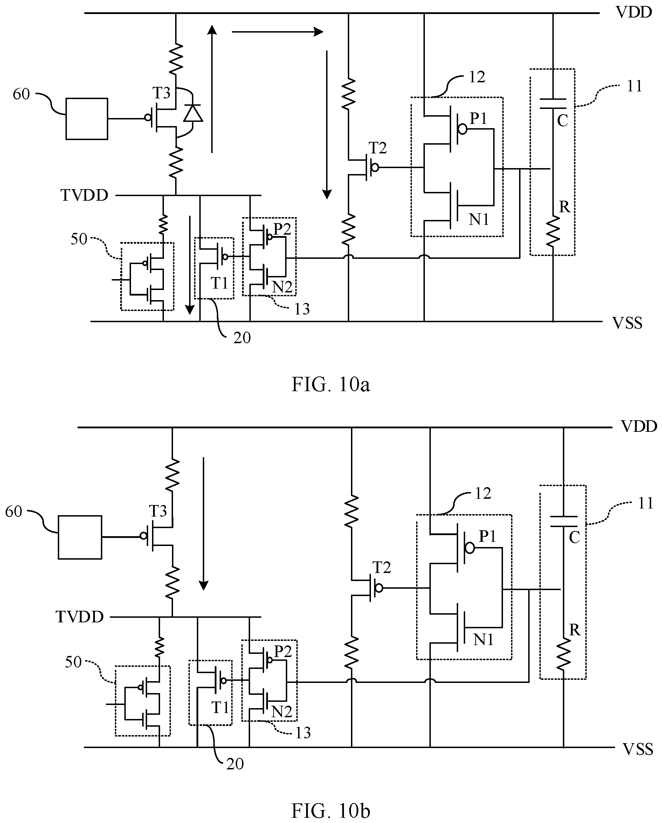

In still another embodiment, as shown in FIG. 10a and FIG. 10b, the foregoing first switch 20 includes a first transistor T1, and the second switch 30 includes a second transistor T2. The control circuit 10 includes a detection circuit 11, a first inverter 12, and a second inverter 13. Both the first transistor T1 and the second transistor T2 are P-type transistors. A first electrode of the first transistor T1 is coupled to a first voltage end TVDD, and a second electrode is coupled to a ground end VSS. A first electrode of the second transistor T2 is coupled to a second voltage end VDD, and a second electrode is coupled to the ground end VSS.

The detection circuit 11 may be an RC circuit. The detection circuit 11 includes a resistor R, a capacitor C, and an output end coupled between the resistor R and the capacitor C. The capacitor C is coupled between the second voltage end VDD and the output end of the RC circuit, and the resistor R is coupled between the ground end VSS and the output end of the RC circuit.

A control end of the first inverter 12 is coupled to the output end of the RC circuit, an input end of the first inverter 12 is separately coupled to the second voltage end VDD and the ground end VSS, and an output end of the first inverter 12 is coupled to a gate of the second transistor T2. Specifically, the first inverter 12 may include a first P-type transistor P1 and a first N-type transistor N1. A gate of the first P-type transistor P1 is coupled to the output end of the RC circuit, a first electrode of the first P-type transistor P1 is coupled to the second voltage end VDD, and a second electrode of the first P-type transistor P1 is coupled to the gate of the second transistor T2. A gate of the first N-type transistor N1 is coupled to the output end of the RC circuit, a first electrode of the first N-type transistor N1 is coupled to the ground end VSS, and a second electrode of the first N-type transistor N1 is coupled to the gate of the second transistor T2.

A control end of the second inverter 13 is coupled to the output end of the RC circuit, an input end of the second inverter 13 is separately coupled to the first voltage end TVDD and the ground end VSS, and an output end of the second inverter 13 is coupled to a gate of the first transistor T1. Specifically, the second inverter 13 may include a second P-type transistor P2 and a second N-type transistor N2. A gate of the second P-type transistor P2 is coupled to the output end of the RC circuit, a first electrode of the second P-type transistor P2 is coupled to the first voltage end TVDD, and a second electrode of the second P-type transistor P2 is coupled to the gate of the first transistor T1. A gate of the second N-type transistor N2 is coupled to the output end of the RC circuit, a first electrode of the second N-type transistor N2 is coupled to the ground end VSS, and a second electrode of the second N-type transistor N2 is coupled to the gate of the first transistor T1.

Based on the circuit structure in this embodiment, an electrostatic discharge protection circuit may work in an electrostatic discharge phase and a normal working phase.

As shown in FIG. 10a, in the electrostatic discharge phase, a chip generates an electric charge due to reasons such as manufacturing, transportation, packaging, or testing. If the chip is in contact with the ground, electrostatic discharge occurs, and an electric charge on the first voltage end TVDD flows to a low electric potential through the second voltage end VDD. The electric charge flows to the second voltage end VDD, and a voltage of the second voltage end VDD is rapidly pulled up. It should be noted herein that, in comparison with a voltage of the ground end VSS, the voltage of the second voltage end VDD and a voltage of the first voltage end TVDD are high electrical levels.

In some possible implementations, the electrostatic discharge protection circuit may further include a third transistor T3. In the electrostatic discharge phase, a gate of the third transistor T3 is floated (in other words, no voltage is applied to the gate of the third transistor T3, or a high electrical level and a low electrical level are not input to the third transistor T3), so that a source, a body end, and a drain electrode of the third transistor T3 may form a diode. The electric charge on the first voltage end TVDD may flow to the low electric potential through the diode. The third transistor T3 may be a P-type transistor.

When detecting that the first voltage end TVDD sends an electrostatic signal to the second voltage end VDD, the RC circuit determines that flowing of the electric charge on the first voltage end TVDD to the second voltage end VDD is an electrostatic discharge event. The output end of the RC circuit outputs a detection signal. Because the capacitor C is coupled between the second voltage end VDD and the output end of the RC circuit, the capacitor C has no delay effect on the high electrical level of the second voltage end VDD, and the high electrical level of the second voltage end VDD may pull up the output end of the RC circuit through the capacitor C. Therefore, the detection signal output from the RC circuit is also a high electrical level.

In this embodiment of this application, the RC circuit may identify a rising edge of a pulse of the second voltage end VDD; when the rising edge of the pulse matches a rising edge of a pulse of an electrostatic voltage, determine that flowing of the electric charge on the first voltage end TVDD to the second voltage end VDD is the electrostatic discharge event; and output the detection signal. For example, if the rising edge of the pulse of the electrostatic voltage is at an ns level to a µs level, the RC circuit determines that flowing of the electric charge on the first voltage end TVDD to the second voltage end VDD is the electrostatic discharge event. Certainly, in another scenario, the rising edge of the pulse of the electrostatic voltage may be further in another time range. This is not limited in this embodiment of this application, provided that a manner in which the RC circuit identifies the electrostatic voltage is preset. In other words, when the RC circuit detects that the first voltage end TVDD sends the electrostatic signal to the second voltage end VDD, the level of the second voltage end VDD rises rapidly, and a voltage on the RC circuit increases.

Then, the high electrical level output from the RC circuit may be transmitted to the gate of the first P-type transistor P1, the gate of the first N-type transistor N1, the gate of the second P-type transistor P2, and the gate of the second N-type transistor N2, and is used as an enable signal of the first P-type transistor P1, the first N-type transistor N1, the second P-type transistor P2, and the second N-type transistor N2. Under control of the high electrical level, the first N-type transistor N1 and the second N-type transistor N2 are turned on, and the first P-type transistor P1 and the second P-type transistor P2 are switched off. After being turned on, the first N-type transistor N1 may send a control signal to the first transistor T1 and the second transistor T2. In other words, the first electrode of the first N-type transistor N1 sends a low electrical level of the ground end VSS to the gate of the second transistor T2 through the second electrode of the first N-type transistor N1. After being turned on, the second N-type transistor N2 may send a control signal to the first transistor T1 and the second transistor T2. In other words, the first electrode of the second N-type transistor N2 sends the low electrical level of the ground end VSS to the gate of the first transistor T1 through the second electrode of the second N-type transistor N2.

Because the first transistor T1 and the second transistor T2 are the P-type transistors, the first transistor T1 and the second transistor T2 are turned on under control of the low electrical level. An electrostatic voltage on the first voltage end TVDD may be discharged to the ground end VSS through the first transistor T1 and the second transistor T2 separately.

It should be noted herein that, even if an electrostatic discharge effect of the second transistor T2 is not good because impedance between the first voltage end TVDD and the second voltage end VDD is high, discharge of the electrostatic voltage on the first voltage end TVDD to the ground end VSS through the first transistor T1 is not affected. In addition, although the first voltage end TVDD may further indirectly control the first transistor T1 to be turned on, at least a part of the electrostatic voltage may be discharged through the second transistor T2. Therefore, even if the first voltage end TVDD is powered on extremely quickly, the first switch 20 is not turned on by mistake. This avoids leakage of a working voltage of the first voltage end TVDD through the first switch 20.

In addition, the first N-type transistor N1 of the first inverter 12 and the second N-type transistor N2 of the second inverter 13 have channel impedance when being turned on. For the solution in which the control circuit 10 shown in FIG. 5a does not include the second inverter 13, the first N-type transistor N1 is coupled to the gate of the first transistor T1 through a long path. Consequently, channel impedance reaching the gate of the first transistor T1 further increases. After the first N-type transistor N1 transmits a voltage of the ground end VSS to the first transistor T1, a part of the voltage needs to be distributed to the gate of the first transistor T. As a result, a voltage that is transmitted to the gate of the first transistor T1 and that is used to turn on the first transistor T1 is reduced, and the first transistor T1 is not fully turned on, in other words, the first transistor T1 is weakly turned on. This leads to low efficiency of the electrostatic discharge from the first voltage end TVDD through the first transistor T1.

However, for the solution in which the control circuit 10 in this embodiment includes the second inverter 13, the RC circuit may directly send the high electrical level to the gate of the second N-type transistor N2. Although the second N-type transistor N2 also has channel impedance, a path through which the second N-type transistor N2 is coupled to the gate of the first transistor T1 is short, and after the second N-type transistor N2 transmits the voltage of the first voltage end TVDD to the first transistor T1, the voltage distributed to the gate of the first transistor T1 is small, and the first transistor T1 may be fully turned on, in other words, the first transistor T1 is strongly turned on. In this way, efficiency of the electrostatic discharge from the first voltage end TVDD through the first transistor T1 is not affected. Therefore, in comparison with the solution in which the control circuit 10 does not include the second inverter 13, in this embodiment, the efficiency of the electrostatic discharge from the first voltage end TVDD through the first transistor T1 can be improved.

Certainly, in comparison with the solution in which the control circuit 10 in this embodiment includes the second inverter 13, in the solution shown in FIG. 5a, because the control circuit 10 does not include the second inverter 13, a layout area of the electrostatic discharge protection circuit can be reduced.

As shown in FIG. 10b, in the normal working phase, the second voltage end VDD may be coupled to a power supply, and the power supply inputs the working voltage to the first voltage end TVDD through the second voltage end VDD, so that a protected component 50 normally works between the first voltage end TVDD and the ground end VSS.

In some possible implementations, the electrostatic discharge protection circuit may further include a drive circuit 60. In the normal working phase, the drive circuit 60 may provide a low electrical level to the gate of the third transistor T3, to enable the third transistor T3 to be turned on. Further, the second voltage end VDD may send the working voltage to the first voltage end TVDD through the third transistor T3.

In addition, in the normal working phase, if an electrostatic voltage exists in another circuit in the chip except a protected circuit 200, and the electrostatic voltage is transmitted to the second voltage end VDD and the first voltage end TVDD through the power supply, once the RC circuit determines that flowing of an electric charge to the second voltage end VDD through the power supply is an electrostatic discharge event, the RC circuit may also output a high electrical level to the first inverter 12 and the second inverter 13, to enable the second N-type transistor N2 to be turned on. The second N-type transistor N2 sends the low electrical level of the ground end VSS to the gate of the first transistor T1, to enable the first transistor T1 to be turned on. In this way, the electrostatic voltage transmitted from the power supply to the first voltage end TVDD is discharged to the ground end VSS through the first transistor T1.

In this case, because the first transistor T1 is connected in parallel to the protected component 50, when the electrostatic voltage transmitted from the power supply to the first voltage end TVDD is discharged through the first transistor T1, normal working of the protected circuit 200 is not affected. In addition, because the first voltage end TVDD discharges the electrostatic voltage through the first transistor T1, a case in which the protected component 50 is damaged because a total voltage on a path from the first voltage end TVDD to the ground end VSS is high, in other words, a clamping voltage between the first voltage end TVDD and the ground end VSS is high may be further avoided.

In addition, it should be noted that, in this embodiment, an example in which the electrostatic discharge protection circuit includes the first switch 20 and the second switch 30 is used to describe a working principle of the electrostatic discharge protection circuit. However, when the electrostatic discharge protection circuit includes the first switch 20 but does not include the second switch 30, the control circuit 10 may include the RC circuit and the second inverter 13, and a connection relationship between the RC circuit and the second inverter 13 and working principles of the RC circuit and the second inverter 13 are the same as those in this embodiment. Details are not described herein again.

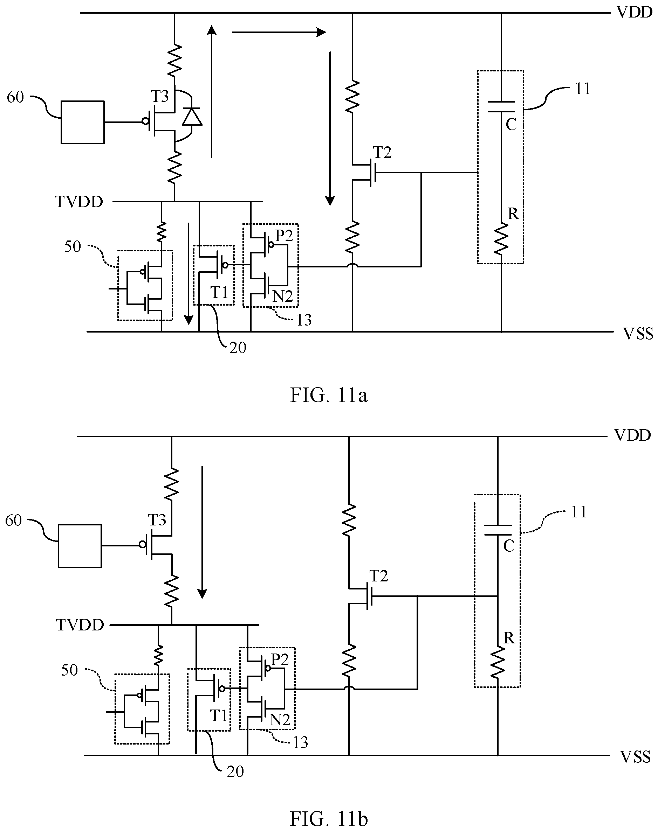

In still another embodiment, as shown in FIG. 11a and FIG. 11b, when a control circuit 10 does not include a first inverter 12 but includes a second inverter 13, in this embodiment of this application, a first transistor T1 may be a P-type transistor, a second transistor T2 may be an N-type transistor, a gate of the first transistor T1 may be coupled to the second inverter 13, and a gate of the second transistor T2 may be coupled to an output end of an RC circuit. In addition, other circuit structures in the solutions shown in FIG. 11a and FIG. 11b are the same as other circuit structures in the solutions shown in FIG. 10a and FIG. 10b.

Based on the circuit structure in this embodiment, an electrostatic discharge protection circuit may work in an electrostatic discharge phase and a normal working phase.

As shown in FIG. 11a, in the electrostatic discharge phase, a chip generates an electric charge due to reasons such as manufacturing, transportation, packaging, or testing. If the chip is in contact with the ground, electrostatic discharge occurs, and an electric charge on a first voltage end TVDD flows to a low electric potential through a second voltage end VDD. The electric charge flows to the second voltage end VDD, and a voltage of the second voltage end VDD is rapidly pulled up. It should be noted herein that, in comparison with a voltage of a ground end VSS, the voltage of the second voltage end VDD and a voltage of the first voltage end TVDD are high electrical levels.

In some possible implementations, the electrostatic discharge protection circuit may further include a third transistor T3. In the electrostatic discharge phase, a gate of the third transistor T3 is floated (in other words, no voltage is applied to the gate of the third transistor T3, or a high electrical level and a low electrical level are not input to the third transistor T3), so that a source, a body end, and a drain electrode of the third transistor T3 may form a diode. The electric charge on the first voltage end TVDD may flow to the low electric potential through the diode. The third transistor T3 may be a P-type transistor.

When detecting that the first voltage end TVDD sends an electrostatic signal to the second voltage end VDD, the RC circuit determines that flowing of the electric charge on the first voltage end TVDD to the second voltage end VDD is an electrostatic discharge event. The output end of the RC circuit outputs a detection signal. Because a capacitor C is coupled between the second voltage end VDD and the output end of the RC circuit, the capacitor C has no delay effect on the high electrical level of the second voltage end VDD, and the high electrical level of the second voltage end VDD may pull up the output end of the RC circuit through the capacitor C. Therefore, the detection signal output from the RC circuit is also a high electrical level.

In this embodiment of this application, the RC circuit may identify a rising edge of a pulse of the second voltage end VDD; when the rising edge of the pulse matches a rising edge of a pulse of an electrostatic voltage, determine that flowing of the electric charge on the first voltage end TVDD to the second voltage end VDD is the electrostatic discharge event; and output the detection signal. For example, if the rising edge of the pulse of the electrostatic voltage is at an ns level to a µs level, the RC circuit determines that flowing of the electric charge on the first voltage end TVDD to the second voltage end VDD is the electrostatic discharge event. Certainly, in another scenario, the rising edge of the pulse of the electrostatic voltage may be further in another time range. This is not limited in this embodiment of this application, provided that a manner in which the RC circuit identifies the electrostatic voltage is preset. In other words, when the RC circuit detects that the first voltage end TVDD sends the electrostatic signal to the second voltage end VDD, the level of the second voltage end VDD rises rapidly, and a voltage on the RC circuit increases.

Then, the high electrical level output from the RC circuit may be transmitted to a gate of a second P-type transistor P2, a gate of a second N-type transistor N2, and the gate of the second transistor T2, and is used as an enable signal of the second P-type transistor P2, the second N-type transistor N2, and the second transistor T2. Under control of the high electrical level, the second N-type transistor N2 and the second transistor T2 are turned on, and the second P-type transistor P2 is switched off. After being turned on, the second N-type transistor N2 may send a control signal to the first transistor T1. In other words, a first electrode of the second N-type transistor N2 sends a low electrical level of the ground end VSS to the gate of the first transistor T1 through a second electrode of the second N-type transistor N2. Because the first transistor T1 is the P-type transistor, the first transistor T1 is turned on under control of the low electrical level. An electrostatic voltage on the first voltage end TVDD may be discharged to the ground end VSS through the first transistor T1 and the second transistor T2 separately.

It should be noted herein that, even if an electrostatic discharge effect of the second transistor T2 is not good because impedance between the first voltage end TVDD and the second voltage end VDD is high, discharge of the electrostatic voltage on the first voltage end TVDD to the ground end VSS through the first transistor T1 is not affected. In addition, although the first voltage end TVDD may further indirectly control the first transistor T1 to be turned on, at least a part of the electrostatic voltage may be discharged through the second transistor T2. Therefore, even if the first voltage end TVDD is powered on extremely quickly, a first switch 20 is not turned on by mistake. This avoids leakage of a working voltage of the first voltage end TVDD through the first switch 20.

For the solution in which the control circuit 10 in this embodiment includes the second inverter 13, the RC circuit may directly send the high electrical level to the gate of the second N-type transistor N2. Although the second N-type transistor N2 also has channel impedance, a path through which the second N-type transistor N2 is coupled to the gate of the first transistor T1 is short, and after the second N-type transistor N2 transmits the voltage of the first voltage end TVDD to the first transistor T1, a voltage distributed to the gate of the first transistor T1 is small, and the first transistor T1 may be fully turned on, in other words, the first transistor T1 is strongly turned on. In this way, efficiency of the electrostatic discharge from the first voltage end TVDD through the first transistor T1 is not affected. Therefore, in comparison with the solution in which the control circuit 10 does not include the second inverter 13, in this embodiment, the efficiency of the electrostatic discharge from the first voltage end TVDD through the first transistor T1 can be improved.

Certainly, in comparison with the solution in which the control circuit 10 in this embodiment includes the second inverter 13, in the solution shown in FIG. 7a, because the control circuit 10 does not include the second inverter 13, a layout area of the electrostatic discharge protection circuit can be reduced.

As shown in FIG. 11b, in the normal working phase, the second voltage end VDD may be coupled to a power supply, and the power supply inputs the working voltage to the first voltage end TVDD through the second voltage end VDD, so that a protected component 50 normally works between the first voltage end TVDD and the ground end VSS.

In some possible implementations, the electrostatic discharge protection circuit may further include a drive circuit 60. In the normal working phase, the drive circuit 60 may provide a low electrical level to the gate of the third transistor T3, to enable the third transistor T3 to be turned on. Further, the second voltage end VDD may send the working voltage to the first voltage end TVDD through the third transistor T3.

In addition, in the normal working phase, if an electrostatic voltage exists in another circuit in the chip except a protected circuit 200, and the electrostatic voltage is transmitted to the second voltage end VDD and the first voltage end TVDD through the power supply, once the RC circuit determines that flowing of an electric charge to the second voltage end VDD through the power supply is an electrostatic discharge event, the RC circuit may also output a high electrical level to the second inverter 13, and input, to the first transistor T1 after the second inverter 13 inverts the high electrical level, a low electrical level obtained through inversion, to enable the first transistor T1 to be turned on. In this way, the electrostatic voltage transmitted from the power supply to the first voltage end TVDD is discharged to the ground end VSS through the first transistor T1.

In this case, because the first transistor T1 is connected in parallel to the protected component 50, when the electrostatic voltage transmitted from the power supply to the first voltage end TVDD is discharged through the first transistor T1, normal working of the protected circuit 200 is not affected. In addition, because the first voltage end TVDD discharges the electrostatic voltage through the first transistor T1, a case in which the protected component 50 is damaged because a total voltage on a path from the first voltage end TVDD to the ground end VSS is high, in other words, a clamping voltage between the first voltage end TVDD and the ground end VSS is high may be further avoided.

In addition, it should be noted that, in this embodiment, an example in which the electrostatic discharge protection circuit includes the first switch 20 and a second switch 30 is used to describe a working principle of the electrostatic discharge protection circuit. However, when the electrostatic discharge protection circuit includes the first switch 20 but does not include the second switch 30, the control circuit 10 may include the RC circuit and the second inverter 13, and a connection relationship between the RC circuit and the second inverter 13 and working principles of the RC circuit and the second inverter 13 are the same as those in this embodiment. Details are not described herein again.

The foregoing describes embodiments of this application with reference to the accompanying drawings. However, this application is not limited to the foregoing specific implementations. The foregoing specific implementations are merely illustrative rather than restrictive. Inspired by this application, a person of ordinary skill in the art may further develop many other manners without departing from the purpose of this application and the protection scope of the claims, and all such manners shall fall within the protection of this application.

## Claims

1. An electrostatic discharge protection circuit, comprising a control circuit, a first clamping circuit, a first voltage end, a second voltage end, and a ground end, wherein a first switch and a protected component are coupled in parallel between the first voltage end and the ground end;
the second voltage end is configured to supply a working voltage to the first voltage end;
the control circuit is configured to: when detecting that the first voltage end sends an electrostatic signal to the second voltage end, send a control signal to the first switch; and
the first switch is configured to be turned on under control of the control signal.

2. The electrostatic discharge protection circuit according to claim 1, wherein the electrostatic discharge protection circuit further comprises a second switch, and the second switch is coupled between the second voltage end and the ground end;
the control circuit is further configured to: when detecting that the first voltage end sends the electrostatic signal to the second voltage end, send the control signal to the second switch; and
the second switch is configured to be turned on under the control of the control signal.

3. The electrostatic discharge protection circuit according to claim 2, wherein the control circuit comprises a detection circuit, and the detection circuit is connected in series between the second voltage end and the ground end; and
the detection circuit is configured to: when detecting that the first voltage end sends the electrostatic signal to the second voltage end, output a detection signal.

4. The electrostatic discharge protection circuit according to claim 3, wherein the detection signal is used as the control signal; and the detection circuit is further configured to send the detection signal to the second switch.

5. The electrostatic discharge protection circuit according to claim 3, wherein the control circuit further comprises a first inverter, the first inverter is coupled between the second voltage end and the ground end, and a control end of the first inverter is coupled to an output end of the detection circuit; and
the first inverter is configured to: invert the detection signal to obtain the control signal, and output the control signal, wherein the detection signal and the control signal are high and low electrical levels of each other.

6. The electrostatic discharge protection circuit according to claim 5, wherein the first inverter is further configured to send the control signal to the second switch.

7. The electrostatic discharge protection circuit according to claim 4 or 6, wherein the second switch comprises a second transistor, a first electrode of the second transistor is coupled to the second voltage end, and a second electrode of the second transistor is coupled to the ground end; and
when the detection circuit sends the control signal to the second switch, a gate of the second transistor is coupled to the detection circuit; or
when the first inverter sends the control signal to the second switch, a gate of the second transistor is coupled to the first inverter.

8. The electrostatic discharge protection circuit according to any one of claims 3 to 4 and 7, wherein the detection circuit is further configured to: when the detection signal is used as the control signal, send the detection signal to the first switch.

9. The electrostatic discharge protection circuit according to any one of claims 5 to 7, wherein the first inverter is further configured to send the control signal to the first switch.

10. The electrostatic discharge protection circuit according to claim 8 or 9, wherein the first switch further comprises a first transistor, a first electrode of the first transistor is coupled to the first voltage end, and a second electrode of the first transistor is coupled to the ground end; and
when the detection circuit sends the control signal to the first switch, a gate of the first transistor is coupled to the detection circuit; or
when the first inverter sends the control signal to the first switch, a gate of the first transistor is coupled to the first inverter.

11. The electrostatic discharge protection circuit according to any one of claims 3 to 7, wherein the control circuit further comprises a second inverter;
the detection circuit is further configured to: when detecting that the first voltage end sends the electrostatic signal to the second voltage end, send the detection signal to the second inverter; and
the second inverter is configured to: invert the detection signal to obtain a control signal, and send the control signal to the first switch.

12. The electrostatic discharge protection circuit according to claim 11, wherein the first switch further comprises a first transistor; and
a gate of the first transistor is coupled to the second inverter, a first electrode is coupled to the first voltage end, and a second electrode is coupled to the ground end.

13. The electrostatic discharge protection circuit according to any one of claims 3 to 10, wherein the detection circuit is a resistor-capacitor circuit; and
the resistor-capacitor circuit comprises a resistor, a capacitor, and an output end coupled between the resistor and the capacitor.

14. The electrostatic discharge protection circuit according to claim 13, wherein the resistor is coupled between the second voltage end and the output end of the capacitor-resistor circuit, and the capacitor is coupled between the output end of the capacitor-resistor circuit and the ground end; and
when the first switch and the second switch receive the control signal sent by the first inverter, or when the first switch receives the control signal sent by a second inverter and the second switch receives the control signal sent by the first inverter, the first transistor of the first switch and the second transistor of the second switch are N-type transistors; or
when the first switch and the second switch receive the control signal sent by the detection circuit, the first transistor of the first switch and the second transistor of the second switch are P-type transistors.

15. The electrostatic discharge protection circuit according to claim 13, wherein the capacitor is coupled between the second voltage end and the output end of the capacitor-resistor circuit, and the resistor is coupled between the output end of the capacitor-resistor circuit and the ground end; and
when the first switch and the second switch receive the control signal sent by the first inverter, or when the first switch receives the control signal sent by a second inverter and the second switch receives the control signal sent by the first inverter, the first transistor of the first switch and the second transistor of the second switch are P-type transistors; or
when the first switch and the second switch receive the control signal sent by the detection circuit, the first transistor of the first switch and the second transistor of the second switch are N-type transistors.

16. The electrostatic discharge protection circuit according to any one of claims 1 to 15, wherein the electrostatic discharge protection circuit further comprises a third transistor, and the third transistor is coupled between the first voltage end and the second voltage end; and
when the second voltage end supplies the working voltage to the first voltage end, the third transistor is used as a triode; or
when the first voltage end sends the electrostatic signal to the second voltage end, the third transistor is used as a diode.

17. A chip, comprising the electrostatic discharge protection circuit according to any one of claims 1 to 16.

18. A terminal, comprising the chip according to claim 17.
